# FASCICULE DE BREVET EUROPEEN

(11) **EP 1 022 855 B1**
(45) Date de publication et mention de la délivrance du brevet: **21.07.2004**
(21) Numéro de dépôt: 00400083.2
(22) Date de dépôt: 13.01.2000
(51) Int. Cl.: H03K 4/69, H03K 4/62, H04N 3/16

(54) **Procédé et dispositif de commande d'un circuit de déviation verticale d'un spot balayant un écran, en particulier pour télé viseur ou moniteur informatique**
Steuerungsvorrichtung und -verfahren einer vertikalen Ablenkschaltung eines einen Bildschirm abtastenden Punktes, insbesondere für Fernsehen oder Computermonitor
Control device and method for a vertical deflection circuit of a spot scanning a screen, in particular for television or computer monitor

(30) Priorité: 22.01.1999 FR 9900715; 04.11.1999 FR 9913822
(43) Date de publication de la demande: 26.07.2000
(73) Titulaire: STMicroelectronics S.A., 92120 Montrouge (FR)
(72) Inventeur: Maige, Philippe, 38170 Seyssinet-Pariset (FR); Guedon, Yannick, 38360 Sassenage (FR)
(74) Mandataire: Casalonga, Axel

(56) Documents cités:
- EP-A- 0 297 476
- US-A- 4 031 430
- US-A- 4 262 235
- PATENT ABSTRACTS OF JAPAN vol. 007, no. 004 (E-151), 8 janvier 1983 (1983-01-08) & JP 57 162575 A (FUJITSU KK), 6 octobre 1982 (1982-10-06)
- PATENT ABSTRACTS OF JAPAN vol. 005, no. 129 (E-070), 19 août 1981 (1981-08-19) & JP 56 066975 A (SANYO ELECTRIC CO LTD;OTHERS: 01), 5 juin 1981 (1981-06-05)
- PATENT ABSTRACTS OF JAPAN vol. 098, no. 011, 30 septembre 1998 (1998-09-30) & JP 10 164385 A (SANYO ELECTRIC CO LTD), 19 juin 1998 (1998-06-19)

## Description

L'invention concerne la commande de la déviation verticale d'un spot balayant un écran.

L'invention s'applique avantageusement mais non limitativement aux écrans de téléviseurs et/ou de moniteurs informatiques.

Un spot balaye un écran selon deux directions orthogonales, à savoir un balayage-ligne et un balayage vertical. Le balayage-ligne s'effectue à une fréquence beaucoup plus élevée que le balayage vertical. Ainsi, à titre indicatif, pour une application de télévision, le balayage-ligne peut s'effectuer à 15625 Hz, tandis que le balayage vertical s'effectue par exemple à 50 Hz. Lorsque le spot a subi un balayage-ligne aller, il se produit alors un retour ligne pour effectuer le balayage de la ligne suivante. Simultanément au balayage-ligne, le balayage vertical permet au spot de balayer l'écran de haut en bas. A l'issue du balayage vertical aller, il se produit alors un retour rapide du spot en haut et à gauche de l'écran (retour trame) et communément appelé par l'homme du métier en langue anglaise "Flyback".

La déviation verticale du spot comporte donc une phase aller de balayage vertical suivie d'une phase de retour rapide du spot. La déviation verticale est générée par un circuit de déviation verticale, classiquement inductif, générant un champ magnétique de déviation du spot.

Les dispositifs de commande classiques de circuits de déviation verticale (ou plus simplement "déviateurs verticaux") sont essentiellement formés d'amplificateurs fonctionnant en classe AB (linéaire), c'est-à-dire dont l'étage de sortie est formé de transistors travaillant dans leur domaine linéaire et produisant par conséquent une tension de sortie continue. L'amplificateur amplifie un signal de consigne, généralement en forme de dents de scie, de façon à délivrer un signal de commande de balayage vertical du spot. Par ailleurs, afin d'assurer le retour rapide du spot, ces dispositifs de commande sont équipés de moyens de génération d'une surtension aux bornes du déviateur.

Actuellement, de tels dispositifs de commande ont un rendement réel de l'ordre de 50% et nécessitent généralement des dissipateurs de chaleur relativement importants.

L'invention vise à remédier à cet inconvénient et l'un des buts de l'invention est d'augmenter le rendement d'un tel circuit de commande tout en diminuant la complexité des dissipateurs de chaleur, de façon à réduire le coût global du dispositif de commande.

L'invention a encore pour but de réaliser de tels dispositifs de commande sous forme de circuits intégrés.

L'invention propose donc un procédé de commande d'un circuit de déviation verticale d'un spot balayant un écran, procédé dans lequel on commande le balayage vertical du spot par l'intermédiaire d'un étage amplificateur de sortie alimenté par une alimentation principale (par exemple ± 15 Volts), et on commande le retour rapide du spot en délivrant au circuit de déviation verticale une surtension produite par une alimentation auxiliaire.

Selon une caractéristique générale de l'invention, l'étage de sortie est un étage à au moins deux transistors que l'on fait fonctionner en classe D (c'est-à-dire de façon alternée, bloqué et conducteur) au moins pour la commande du balayage vertical du spot. On délivre ladite surtension en commandant un premier interrupteur bidirectionnel connecté à l'étage de sortie et à l'alimentation auxiliaire de façon à autoriser la circulation d'un courant à travers ce premier interrupteur. Et, on commande un deuxième interrupteur bidirectionnel connecté entre un premier transistor de l'étage de sortie et une première borne (par exemple + Vcc) de l'alimentation principale, de façon à empêcher la circulation d'un courant à travers le premier interrupteur pendant le balayage vertical du spot et empêcher ainsi la délivrance de ladite surtension pendant le balayage vertical du spot.

En classe D, les transistors fonctionnent en mode bloqué-passant, c'est-à-dire que lorsque l'un d'eux est bloqué, l'autre est passant et vice versa. En classe D, un transistor bloqué ne dissipe pas de puissance, tandis qu'il dissipe très peu lorsqu'il est passant. La tension de sortie de l'étage de sortie est un signal "haut" ou "bas". Si la durée à l'état haut est égale à celle de l'état bas, la valeur moyenne du signal de sortie est nulle. En modulant le rapport cyclique du signal de commande (impulsions de commande de largeur variable) des transistors et en filtrant la composante haute fréquence, on récupère une tension moyenne variable dans le temps. Cette variation est très lente devant la fréquence de découpage (fréquence du signal de commande). On peut ainsi obtenir un rendement pouvant aller jusqu'à 90% contre environ 45% à 50% pour un fonctionnement en classe AB.

En outre, en combinaison avec ce fonctionnement en classe D, l'invention prévoit la délivrance de la surtension par la commande d'un premier interrupteur bidirectionnel de façon à autoriser la circulation d'un courant à travers ce premier interrupteur. Par ailleurs, il est nécessaire de prévoir le deuxième interrupteur bidirectionnel qui est commandé de façon à empêcher la circulation d'un courant à travers le premier interrupteur pendant le balayage vertical du spot, et en particulier lorsque dans une deuxième phase du balayage aller, le deuxième transistor de l'étage de sortie est bloqué.

Tous les transistors, que ce soit ceux de l'étage de sortie ou bien ceux formant avantageusement les différents interrupteurs bidirectionnels, peuvent être des transistors bipolaires. Ceci étant, notamment en vue d'une réalisation par circuit intégré, il est particulièrement avantageux que ces transistors soient des transistors à effet de champ à grille isolée (transistors MOS), par exemple à canal N.

Bien qu'en théorie, il ne soit pas nécessaire de connecter sur chaque transistor une diode montée en anti-parallèle à ses bornes, ceci s'avère préférable, tout particulièrement si des transistors bipolaires sont utilisés, afin de permettre une bonne conduction des transistors dans les deux sens, mais également lorsque des transistors MOS sont utilisés de façon à éviter une augmentation de la tension de seuil de ces transistors qui fonctionnent généralement sous forts signaux. En pratique, la diode montée en anti-parallèle est réalisée en reliant la source du transistor au substrat ("bulk" en langue anglaise). On rappelle ici plus généralement, qu'au sens de la présente invention, une diode est dite montée en anti-parallèle aux bornes d'un transistor lorsque l'anode de la diode est reliée à la source du transistor, tandis que la cathode de la diode est reliée au drain du transistor (lorsqu'il s'agit d'un transistor MOS).

Selon un mode de mise en oeuvre de l'invention, le premier interrupteur bidirectionnel comporte un transistor et une diode montée en anti-parallèle aux bornes du transistor, l'anode de la diode étant reliée au premier transistor de l'étage de sortie. Le deuxième interrupteur bidirectionnel, qui permet d'éviter la délivrance de la surtension pendant la commande de balayage vertical du spot, comporte un transistor connecté en série entre le premier transistor d'étage de sortie et la première borne de l'alimentation principale (par exemple + Vcc). Ce deuxième interrupteur bidirectionnel comporte également une diode montée en anti-parallèle aux bornes du transistor, la cathode de cette diode étant reliée au premier transistor de l'étage de sortie et l'anode étant reliée à ladite première borne de l'alimentation principale.

Le balayage vertical du spot comporte une première phase dans laquelle le courant est rentrant dans le circuit de déviation verticale et une deuxième phase dans laquelle le courant est sortant vis-à-vis du circuit de déviation verticale. Par ailleurs, le retour rapide du spot comporte une première phase dans laquelle le courant est sortant vis-à-vis du circuit de déviation verticale et une deuxième phase dans laquelle le courant est rentant dans le circuit de déviation verticale. On bloque alors le transistor du premier interrupteur bidirectionnel (c'est-à-dire celui qui permet la délivrance de la surtension) pendant le balayage vertical, tandis qu'on commande le deuxième interrupteur bidirectionnel (c'est-à-dire celui qui évite la délivrance de la surtension pendant le balayage vertical) en rendant conducteur le transistor de ce deuxième interrupteur bidirectionnel au moins lorsque le deuxième transistor de l'étage de sortie est bloqué pendant la deuxième phase du balayage vertical. Et, on bloque le transistor du deuxième interrupteur bidirectionnel pendant le retour rapide du spot, tandis qu'on rend conducteur le transistor du premier interrupteur bidirectionnel au moins pendant la deuxième phase du retour rapide du spot.

En pratique, pour des raisons de simplicité de commande et de dissipation de puissance, il est préférable de commander la mise en conduction du transistor du deuxième interrupteur bidirectionnel dès le début du balayage vertical du spot, et, pendant le retour rapide du spot, de rendre conducteur le transistor du premier interrupteur bidirectionnel dès que le transistor du deuxième interrupteur bidirectionnel a été bloqué.

Deux variantes sont possibles pour générer la surtension nécessaire au retour rapide du spot. On peut prévoir une alimentation auxiliaire externe ou bien une alimentation auxiliaire dite interne et généralement constituée d'un condensateur, dit condensateur auxiliaire ou de "flyback".

Dans la première variante (alimentation auxiliaire externe), le premier interrupteur bidirectionnel est connecté en série entre l'alimentation auxiliaire et le premier transistor de l'étage de sortie.

Dans la deuxième variante (alimentation auxiliaire interne), l'alimentation auxiliaire comporte un condensateur auxiliaire dont une première borne est reliée d'une part à la première borne de l'alimentation principale (+ Vcc par exemple) par l'intermédiaire du premier interrupteur bidirectionnel, et d'autre part à une deuxième borne de l'alimentation principale (- Vcc par exemple ou bien la masse) par l'intermédiaire d'un interrupteur auxiliaire commandable. La deuxième borne du condensateur (borne positive par exemple) est reliée au premier transistor de l'étage de sortie et au deuxième interrupteur bidirectionnel. L'interrupteur auxiliaire est alors ouvert lorsque le transistor du premier interrupteur bidirectionnel est conducteur et vice versa.

Plus précisément, selon un mode de mise en oeuvre, pendant le balayage vertical du spot, on ferme l'interrupteur auxiliaire et pendant le retour rapide du spot, on ouvre cet interrupteur auxiliaire.

Dans la variante utilisant l'alimentation auxiliaire interne, le transistor du premier interrupteur bidirectionnel est connecté entre la première borne du condensateur auxiliaire et la première borne (+ Vcc par exemple) de l'alimentation principale. Il est alors particulièrement avantageux d'utiliser l'énergie emmagasinée dans le condensateur auxiliaire pour rendre conducteur le transistor de ce premier interrupteur bidirectionnel.

Ainsi, selon un mode de mise en oeuvre de l'invention, on connecte la grille du transistor de ce premier interrupteur bidirectionnel à la première borne du condensateur auxiliaire pour rendre conducteur ce transistor et on connecte la grille du transistor du premier interrupteur bidirectionnel à sa source pour bloquer ce transistor.

Généralement, un condensateur d'auto-élévation (condensateur de "bootstrap" en langue anglaise) est avantageusement connecté entre la source et la grille du premier transistor de l'étage de sortie de façon à faciliter sa mise en conduction.

Dans un mode de mise en oeuvre de l'invention, on utilise avantageusement l'énergie emmagasinée dans ce condensateur d'auto-élévation pour rendre conducteur le transistor du deuxième interrupteur bidirectionnel pendant le balayage vertical du spot.

Et, cette variante de mise en oeuvre utilisant le condensateur d'auto-élévation est compatible avec l'une et l'autre des deux variantes concernant l'alimentation auxiliaire (alimentation auxiliaire externe ou alimentation auxiliaire interne par le biais du condensateur auxiliaire).

Plus précisément, on connecte avantageusement le condensateur d'auto-élévation à la grille du transistor du deuxième interrupteur bidirectionnel pendant le balayage vertical du spot et on relie la grille du transistor de ce deuxième interrupteur bidirectionnel à sa source pendant le retour rapide du spot.

Selon un mode de mise en oeuvre de l'invention permettant de simplifier la commande des transistors, on commande les transistors de l'étage de sortie en classe D compte tenu d'un signal de consigne pendant la phase de balayage vertical du spot et, pendant la phase de retour rapide du spot, on rend conducteur le premier transistor de l'étage de sortie.

Par ailleurs, on peut, en variante, amplifier le signal de consigne contre-réactionné par le courant traversant le circuit de déviation, de façon à délivrer un signal d'erreur. On détecte alors le franchissement d'un seuil prédéterminé par le signal d'erreur et on déclenche la phase de retour rapide du spot lorsque le signal d'erreur franchit le seuil.

L'invention a également pour objet un dispositif de commande d'un circuit de déviation verticale d'un spot balayant un écran, ce dispositif comprenant un étage amplificateur de sortie alimenté par une alimentation principale pour la commande de balayage vertical du spot, et une alimentation auxiliaire capable de délivrer une surtension au circuit de déviation verticale pour un retour rapide du spot.

Selon une caractéristique générale de l'invention, l'étage de sortie est un étage à au moins deux transistors apte à fonctionner en classe D, au moins pour la commande du balayage vertical du spot, cet étage étant associé à un filtre de lissage connecté à la borne commune des deux transistors. Le dispositif comprend par ailleurs un premier interrupteur bidirectionnel commandable connecté à l'étage de sortie et à l'alimentation auxiliaire, ainsi qu'un deuxième interrupteur bidirectionnel commandable connecté entre un premier transistor de l'étage de sortie et une première borne (+ Vcc par exemple) de l'alimentation principale.

Le dispositif comprend également des moyens de contrôle aptes à commander :
- les transistors de l'étage de sortie en classe D,
- le premier interrupteur de façon à autoriser la circulation d'un courant à travers ce premier interrupteur et la délivrance de ladite surtension, et
- le deuxième interrupteur de façon à empêcher la circulation d'un courant à travers le premier interrupteur pendant le balayage vertical du spot et empêcher ainsi la délivrance de ladite surtension pendant le balayage vertical du spot.

Selon un mode de réalisation de l'invention, pendant la commande de balayage vertical du spot, les moyens de contrôle commandent les transistors de l'étage de sortie en classe D compte tenu d'un signal de consigne présent en entrée du dispositif, ouvrent le premier interrupteur bidirectionnel et ferment le deuxième interrupteur bidirectionnel. Pendant la commande de retour rapide du spot, les moyens de contrôle rendent conducteur le premier transistor de l'étage de sortie, ouvrent le deuxième interrupteur bidirectionnel et ferment le premier interrupteur.

Selon un mode de réalisation de l'invention, le dispositif comprend un étage de pré-amplification recevant le signal de consigne contre-réactionné par le courant traversant le circuit de déviation verticale. Cet étage de pré-amplification délivre un signal d'erreur. Le dispositif comprend en outre des moyens de détection aptes à détecter le franchissement d'un seuil prédéterminé par le signal d'erreur. Les moyens de contrôle déclenchent alors la phase de retour rapide du spot lorsque le signal d'erreur franchit ledit seuil.

Il est également possible, en variante, que l'étage de sortie soit formé de quatre transistors selon un montage en pont complet. En d'autres termes, l'étage de sortie comporte alors deux autres transistors aptes à fonctionner en commutation de façon alternée au moins pour la commande de balayage vertical du spot. Le filtre de lissage est alors connecté entre la borne commune des deux premiers transistors et la borne commune des deux autres transistors de l'étage de sortie. Le filtre de lissage se répartit en outre de part et d'autre du circuit de déviation verticale. Bien entendu, dans ce cas, les moyens permettant de générer la surtension nécessaire au retour rapide du spot, ainsi que les moyens permettant d'inhiber la délivrance de cette surtension pendant le balayage vertical du spot, ne sont connectés qu'à une seule paire de transistors du pont.

L'invention a également pour objetrun téléviseur ou un moniteur informatique comprenant un écran, un circuit de déviation verticale d'un spot balayant ledit écran et un dispositif de commande du circuit de déviation verticale tel que celui défini ci-avant.

D'autres avantages et caractéristiques de l'invention apparaîtront à la description de modes de réalisation, nullement limitatifs, et des dessins annexés, sur lesquels :
- la figure 1 illustre très schématiquement l'architecture d'un dispositif de commande selon l'invention,
- la figure 2 illustre plus en détail un mode de réalisation de l'étage de sortie et des moyens de génération de la surtension nécessaire au retour rapide du spot,
- la figure 3 illustre un signal de consigne et un mode de fonctionnement du dispositif selon l'invention,
- la figure 4 illustre un autre mode de réalisation d'un étage de sortie et des moyens de génération de la surtension nécessaire au retour rapide du spot,
- la figure 5 illustre schématiquement un mode de réalisation de l'invention, utilisant l'énergie emmagasinée dans un condensateur d'auto-élévation pour commander le deuxième interrupteur bidirectionnel du dispositif selon l'invention,
- la figure 6 illustre plus en détail et toujours de façon schématique une partie du mode de réalisation illustré sur la figure 5,
- la figure 7 illustre un mode de réalisation de l'invention, utilisant le condensateur auxiliaire (condensateur de flyback) pour commander le premier interrupteur bidirectionnel du dispositif selon l'invention,
- la figure 8 illustre plus en détail une partie du mode de réalisation illustré sur la figure 7, et
- la figure 9 illustre schématiquement une autre variante de réalisation d'un dispositif selon l'invention, comportant un étage de sortie en pont complet.

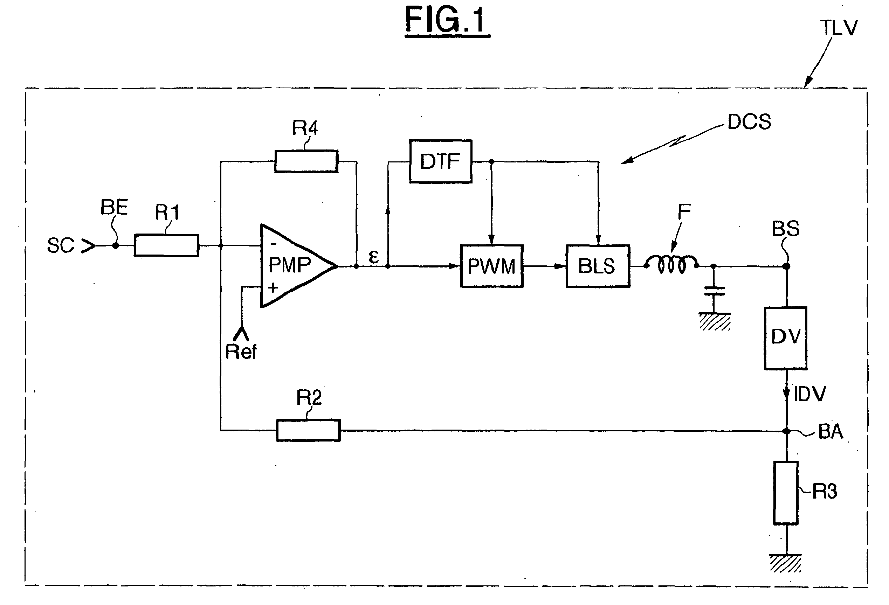

Sur la figure 1, la référence DCS désigne d'une façon générale un dispositif de commande d'un circuit DV de déviation verticale d'un spot balayant un écran, par exemple un écran de télévision ou un écran de moniteur informatique. Ce circuit DCS peut donc être incorporé dans un téléviseur et/ou un moniteur informatique TLV. Le circuit de déviation verticale est de structure classique essentiellement inductive. Le passage d'un courant IDV dans le circuit de déviation verticale crée un champ magnétique permettant la déviation du spot.

Le circuit de commande DCS comporte une borne d'entrée BE recevant un signal de consigne SC dont on reviendra plus en détail ci-après sur la forme, et une borne de sortie BS délivrant un courant IDV dans le déviateur vertical DV.

Le dispositif de commande DCS comporte en tête un étage de pré-amplification PMP, monté dans le cas présent en inverseur, et dont l'entrée inverseuse est reliée à la borne d'entrée BE par l'intermédiaire d'une première résistance R1. L'entrée inverseuse da pré-amplificateur PMP est reliée également par l'intermédiaire d'une deuxième résistance R2 à une autre borne BA du déviateur DV. Cette entrée inverseuse est également reliée à la sortie du pré-amplificateur PMP par une résistance R4. Les résistances R1 et R4 fixent le gain du pré-amplificateur PMP par rapport au signal de consigne et les résistances R2 et R4 fixent le gain pour la boucle de contre-réaction.

Une résistance R3, typiquement de l'ordre de 1 Ohm, relie classiquement le déviateur DV à la masse.

L'entrée non-inverseuse du pré-amplificateur PMP est reliée à une tension de référence Ref.

La sortie du pré-amplificateur PMP délivre un signal d'erreur ε qui va être pris en compte notamment par des moyens de détection DTF dont on reviendra plus en détail ci-après sur la structure et la fonction.

Le dispositif DCS comporte également un bloc de sortie BLS comportant, comme on le verra plus en détail ci-après, un étage de sortie à deux ou quatre transistors fonctionnant en classe D.

Sur la figure 1, un bloc PWM illustré très schématiquement en amont du bloc BLS, reçoit le signal ε et comporte des moyens de contrôle destinés à commander les différents transistors du bloc de sortie BLS. Ces moyens de contrôle comportent notamment, comme on le verra plus en détail ci-après, des moyens de génération d'impulsions de largeurs variables destinées à être appliquées sur les grilles des transistors de l'étage amplificateur de sortie.

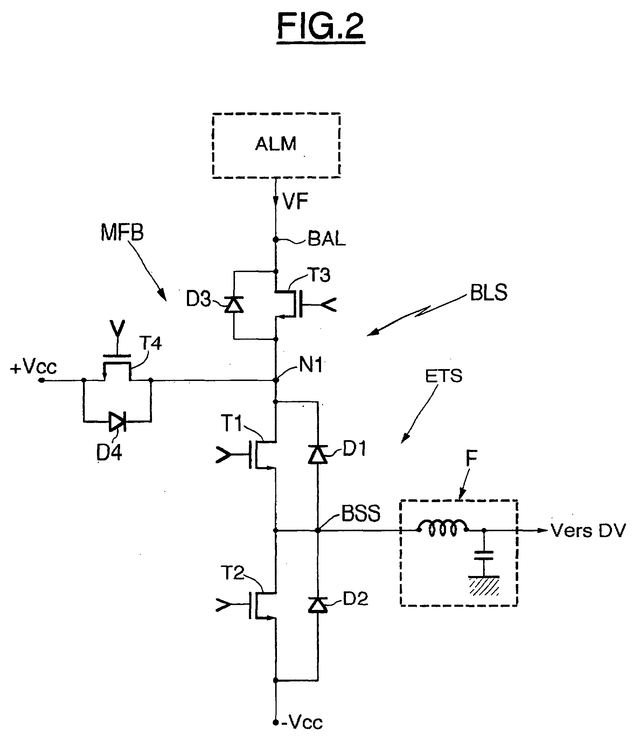

Si l'on se réfère maintenant plus particulièrement à la figure 2, on voit que le bloc de sortie BLS comporte un étage amplificateur de sortie ETS formé ici de deux transistors T1 et T2 en demi-pont. Ces deux transistors T1 et T2 sont ici deux transistors NMOS associés chacun à une diode D1 (respectivement D2) montée en anti-parallèle à leurs bornes. Plus précisément, la cathode de la diode D1 est reliée au drain du transistor T1, tandis que l'anode de la diode D2 est reliée à la source du transistor T2 elle-même reliée à la borne négative - Vcc de l'alimentation principale. L'anode de la diode D1 et la cathode de la diode D2 sont reliées ensemble à la borne commune des transistors T1 et T2 et forment la borne de sortie BSS de cet étage ETS. Cette borne de sortie BSS est reliée à la borne BS du dispositif de commande DCS, et par conséquent au circuit de déviation DV par l'intermédiaire d'un filtre de lissage F, inductif capacitif.

Les grilles des transistors T1 et T2 sont commandées par les moyens de contrôle incorporés dans le bloc PWM.

Les diodes D1 et D2 sont ici réalisées par la liaison de la source de chaque transistor T1, T2 au substrat.

Le bloc BLS comporte par ailleurs des moyens MFB associés à cet étage de sortie ETS et destinés notamment à contrôler la génération de la surtension nécessaire au retour rapide du spot.

Plus précisément, dans la variante décrite sur cette figure 2, et correspondant à une alimentation auxiliaire ALM externe au bloc BLS (par exemple une source de tension auxiliaire de plusieurs dizaines de Volt), les moyens MFB comportent un premier interrupteur bidirectionnel formé ici d'un transistor NMOS T3 dont la source est reliée au drain du premier transistor T1 de l'étage ETS, et dont le drain est relié à une borne BAL destinée à recevoir la tension VF délivrée par l'alimentation auxiliaire ALM. Ce premier interrupteur bidirectionnel comporte également une diode D3 dont l'anode est reliée à la source du transistor T3 et dont la cathode est reliée au drain du transistor T3.

Outre ce premier interrupteur bidirectionnel, les moyens MFB comportent un deuxième interrupteur bidirectionnel formé d'un transistor NMOS T4 et d'une diode D4 montée en anti-parallèle aux bornes du transistor T4. Plus précisément, le drain du transistor T4 et la cathode de la diode D4 sont reliés au drain du premier transistor T1, tandis que la source du transistor T4 et l'anode de la diode D4 sont reliées ensemble à la borne + Vcc de l'alimentation principale.

On va maintenant décrire plus en détail le fonctionnement du dispositif selon l'invention, en se référant plus particulièrement aux figures 1, 2 et 3.

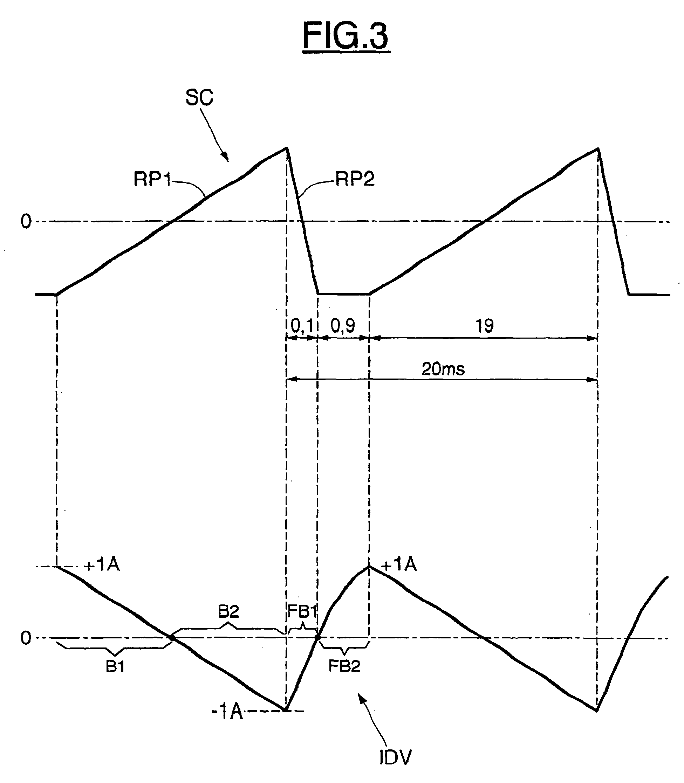

La partie haute de la figure 3 illustre une forme classique d'un signal de consigne SC. Un tel signal SC qui illustre, soit le courant, soit la tension à borne d'entrée BE, se compose d'une succession de rampes RP1 centrées dans l'exemple décrit autour du niveau 0 et ayant chacune typiquement une durée de 19 ms. Chaque rampe RP1 est suivie d'une portion décroissante RP2 ayant une durée de l'ordre de 0,1 ms, elle-même suivie d'une portion plate dont la durée est de l'ordre de 0,9 ms. Bien entendu, ces valeurs numériques sont données ici à titre d'exemple.

La partie basse de la figure 3 illustre l'allure du courant IDV circulant dans le déviateur vertical DV.

A la rampe RP1 du signal de consigne SC, correspond une décroissance linéaire du courant IDV correspondant à la phase de balayage vertical du spot sur l'écran. Cette décroissance s'effectue entre deux valeurs opposées, par exemple ± 1 Ampère. Dans une première phase B1 du balayage, le courant IDV est positif, c'est-à-dire qu'il est sortant vis-à-vis de l'étage de sortie ETS et donc rentrant dans le déviateur DV. Dans la deuxième phase B2 du balayage vertical, le courant IDV est négatif, c'est-à-dire qu'il est sortant vis-à-vis du déviateur DV et par conséquent rentrant vis-à-vis de l'étage ETS.

La phase de retour rapide du spot correspond à la croissance du courant IDV depuis la valeur -1 Ampère jusqu'à la valeur +1 Ampère. Il convient de noter ici que ce retour rapide du spot est initialisé par la portion décroissante RP2 du signal de consigne SC, mais s'effectue sur une durée un peu plus longue, typiquement de l'ordre de 0,8 à 0,9 ms. C'est la raison pour laquelle le signal de consigne SC comporte une partie plane permettant de ne déclencher la rampe suivante que lorsque le spot est effectivement revenu à sa position de départ (en haut et à gauche de l'écran).

Durant cette phase de retour rapide, les moyens MFB créent une surtension, typiquement de l'ordre de quelques dizaines de volts, aux bornes du déviateur DV. Là encore, le retour rapide du spot comporte deux phases, à savoir une première phase FB1 au cours de laquelle le courant IDV est rentrant dans l'étage ETS, et une deuxième phase FB2 au cours de laquelle le courant IDV est sortant vis-à-vis de l'étage ETS.

Pendant le balayage vertical du spot (phases B1 et B2), on rend alternativement les transistors T1 et T2 conducteurs et bloqués à une fréquence de découpage bien plus élevée que la fréquence de balayage vertical (en l'espèce, par exemple supérieure ou égale à 100 kHz). On récupère alors à la borne de sortie BS de l'étage de sortie la valeur moyenne de la tension, au point commun BSS des transistors, que l'on lisse dans le filtre de lissage F, de façon à obtenir l'allure décroissante du courant IDV illustrée sur la figure 3 (phases B1 et B2).

Bien entendu, la largeur des impulsions de commande destinées à rendre conducteur ou bloqué chacun des transistors, dépend de la valeur du signal de consigne, et par conséquent de l'instant courant de la phase de balayage vertical. Ainsi, dans la première phase B 1 du balayage, le transistor T1 sera plus longtemps conducteur que le transistor T2 et vice-versa dans la deuxième phase B2 du balayage. En d'autres termes, la durée d'une impulsion de commande destinée à rendre conducteur le transistor T1, décroît depuis environ 90% de la période de découpage jusqu'à environ 10% de la période de découpage. Simultanément, la durée de l'impulsion de commande destinée à rendre conducteur le transistor T2 croît d'environ 10% de la période de découpage jusqu'à environ 90% de la période de découpage. Lorsque le courant IDV passe par la valeur zéro, chacune des impulsions de commande occupe 50% de la période de découpage.

Pendant les deux phases de balayage B1 et B2, on confère un état bloqué au transistor T3 (premier interrupteur bidirectionnel ouvert) et on rend conducteur le transistor T4 (deuxième interrupteur bidirectionnel fermé).

En conséquence, pendant la première phase du balayage B1, quand le transistor T1 conduit, le courant circule dans le transistor T4, la diode D4 et le transistor T1. Quand le transistor T1 est bloqué, le courant circule dans le transistor T2 et la diode D2.

Dans la deuxième phase B2 du balayage, lorsque le transistor T2 conduit, le courant circule dans le transistor T2. Par contre, lorsque le transistor T2 est bloqué, le courant circule dans le transistor T1 et dans la diode D1, puis dans le transistor T4.

Il convient de noter ici que la présence de l'interrupteur bidirectionnel T4, D4 est indispendable pour éviter que le courant rentrant de recirculation traversant la diode D1 et le transistor T1 ne déclenche prématurément la génération de la surtension VF, lorsque le transistor T2 est bloqué dans la deuxième phase B2 du balayage. En effet, en l'absence de conduction du transistor T4, le courant de recirculation pourrait alors traverser la diode D3 et provoquer la génération d'un début de surtension aux bornes du déviateur, provoquant un début de remontée rapide du spot jusqu'à ce que le transistor T2 soit à nouveau conducteur.

Par contre, en raison de la conduction du transistor T4 et en raison du fait que la surtension VF est choisie supérieure à la tension d'alimentation principale + Vcc, le courant ne circule pas dans la diode D3 et ne provoque pas la génération prématurée de la surtension.

Il convient de noter ici également, qu'il serait nécessaire en théorie de fermer le deuxième interrupteur bidirectionnel (c'est-à-dire de rendre conducteur le transistor T4) uniquement dans la deuxième phase du balayage B2 et pendant les périodes au cours desquelles le transistor T2 est bloqué. Ceci étant, ceci nécessiterait de commander le transistor T4 à la fréquence de découpage élevée. Il est donc beaucoup plus simple de laisser le transistor T4 conducteur pendant toute la durée du balayage vertical du spot (phases B1 et B2).

A l'issue du balayage vertical du spot, on interrompt la commutation des transistors T1 et T2 à la fréquence de découpage (c'est-à-dire le fonctionnement en classe D) et on rend le transistor T1 conducteur. En outre, on ouvre le deuxième interrupteur bidirectionnel, c'est-à-dire qu'on commande le blocage du transistor T4 et on ferme le premier interrupteur bidirectionnel, c'est-à-dire qu'on rend le transistor T3 conducteur. Il en résulte donc la génération d'une surtension aux bornes du déviateur DV et par conséquent le retour rapide du spot. Pendant la première partie FB1 du retour rapide, le courant circule dans la diode D1 et le transistor T1, puis dans la diode D3 et le transistor T3. Pendant la deuxième partie FB2 du retour rapide, le courant circule dans le transistor T3, puis dans le transistor T1.

Il convient de noter ici qu'il aurait été possible de poursuivre pendant cette phase de retour rapide, la commutation alternée des transistors T1 et T2 de l'étage de sortie à la fréquence de découpage. Ceci étant, le fait d'interrompre cette commutation et de rendre le transistor T1 conducteur pendant toute la durée du retour rapide, permet d'appliquer en permanence la surtension VF aux bornes du déviateur (c'est-à-dire sans perte de tension au cours des périodes où le transistor T1 aurait été bloqué).

L'homme du métier aura noté que pour rendre le transistor T4 passant lors de la phase de balayage, il est nécessaire de générer une tension de grille au-dessus de la valeur + Vcc puisque la source du transistor T4 est portée à cette tension + Vcc.

De même, pour rendre le transistor T3 conducteur lors du retour rapide, il faut là encore générer une tension de grille au-dessus de la valeur + Vcc puisque la source du transistor T3 est portée à la valeur + Vcc. Une solution classique peut consister à générer ces tensions supérieures à la valeur + Vcc à partir de pompes de charge de structure connue en soi.

Les moyens de contrôle qui permettent de commander les différents transistors du dispositif de commande selon l'invention, de la façon qui vient d'être décrite, peuvent être également aisément réalisés par l'homme du métier à l'aide de circuits logiques classiques. C'est notamment le cas pour générer les impulsions de commande de largeur variable ainsi que pour commander le transistor T5 (comme indiqué ci-après) et pour commander les transistors T3 et T4 via les pompes de charge.

Par ailleurs, il est avantageux de détecter la fin du balayage vertical du spot afin de pouvoir commander les transistors T3 et T4 pour enclencher la phase de retour rapide. C'e st le rôle des moyens de détection DTF. Ceux-ci sont essentiellement formés d'un comparateur qui compare le signal d'erreur ε à un seuil prédéterminé, par exemple + 0,5 volt.

Lorsqu'à la fin du balayage vertical du spot, le signal d'erreur croît jusqu'à dépasser le seuil, en raison de l'inertie du déviateur, les moyens de détection délivrent alors aux moyens de contrôle un signal de détection en réponse auquel les moyens de contrôle commandent les différents transistors du dispositif de commande comme indiqué ci-avant.

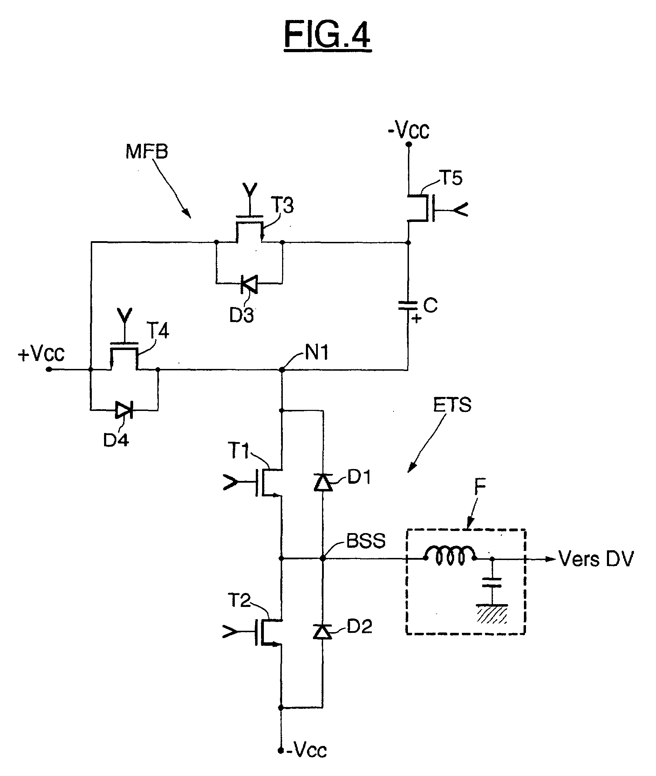

La variante illustrée sur la figure 4 correspond à l'utilisation d'une alimentation auxiliaire interne constituée d'un condensateur auxiliaire C (condensateur de "flyback"). Plus précisément, dans l'exemple illustré, la borne positive du condensateur C est reliée au drain du transistor T1 et au drain du transistor T4, tandis que l'autre borne du condensateur C est reliée à la source du transistor T3, ainsi qu'à la borne - Vcc de l'alimentation principale par l'intermédiaire d'un interrupteur auxiliaire T5 qui peut être également formé d'un transistor NMOS commandé sur sa grille par les moyens de contrôle.

Par ailleurs, dans cette variante, le drain du transistor T3 et la cathode de la diode D3 sont reliés ensemble à la borne + Vcc de l'alimentation principale.

Pendant le balayage vertical du spot, on commande les transistors T1 et T2 comme expliqué ci-avant et on rend les transistors T4 et T5 conducteurs. Le transistor T3 est bloqué.

Pendant la première phase B1 du balayage, le courant passe alors dans le transistor T4 dans la diode D4, puis dans le transistor T1 lorsque celui-ci est conducteur. Quand le transistor T1 est bloqué, le courant passe dans le transistor T2 et dans la diode D2.

Dans la deuxième phase B2 du balayage vertical, le courant passe dans le transistor T2 lorsque celui-ci conduit, et lorsqu'il est bloqué, il passe dans le transistor T1 et la diode D1, puis dans le transistor T4.

A l'issue de la deuxième phase B2 du balayage, le condensateur auxiliaire C est chargé.

La détection de la fin du balayage est effectuée comme expliqué ci-avant. Au cours de la phase de retour rapide du spot, les transistors T4 et T5 sont bloqués par les moyens de contrôle et le transistor T3 est rendu conducteur, de même que le transistor T1.

Pendant la première phase FB1 du retour rapide, le courant passe dans la diode D1 et le transistor T1, puis dans le condensateur C, puis dans le transistor T3 et la diode D3.

Dans la deuxième phase FB2 du retour rapide, le courant, issu de la borne + Vcc traverse le transistor T3 puis le condensateur C et le transistor T1.

La tension présente aux bornes du condensateur C au cours du retour rapide du spot a permis la génération de la surtension. La fonction du transistor T4 est identique à celle qui a été décrite ci-avant pour la variante utilisant l'alimentation auxiliaire externe.

Ainsi qu'il a été décrit ci-avant, une façon de générer des tensions supérieures à la tension d'alimentation + Vcc, consiste à utiliser des pompes de charge. Cependant, celles-ci requièrent un oscillateur, une capacité de pompage, une capacité de stockage, c'est-à-dire la grille du transistor à commander, et un inverseur capable de délivrer en sortie des excursions de tension allant de - Vcc à + Vcc. Outre le fait qu'elles nécessitent des composants supplémentaires, elles délivrent généralement un courant faible.

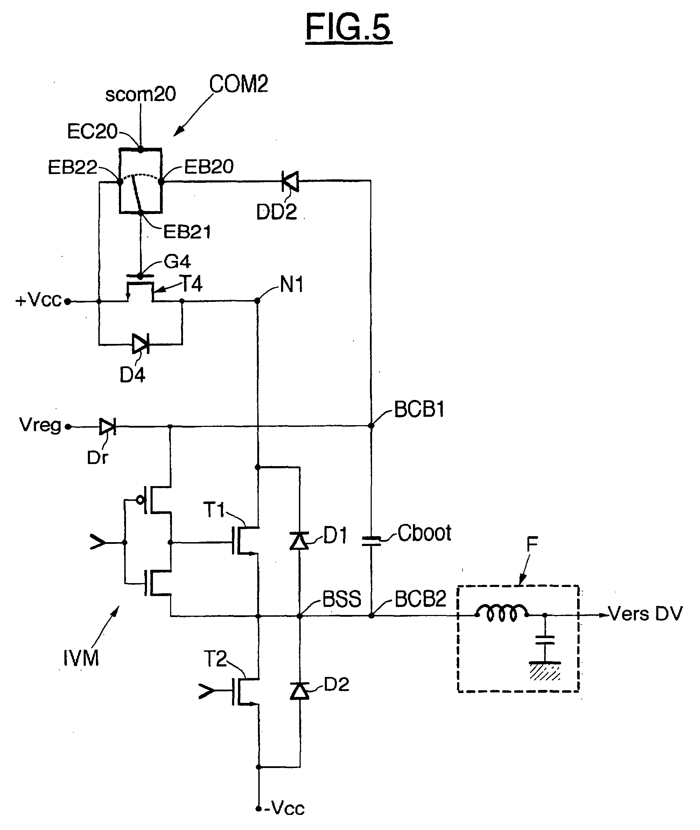

Les modes de réalisation illustrés plus particulièrement sur les figures 5 à 8 permettent de s'affranchir de l'utilisation de telles pompes de charge classiques.

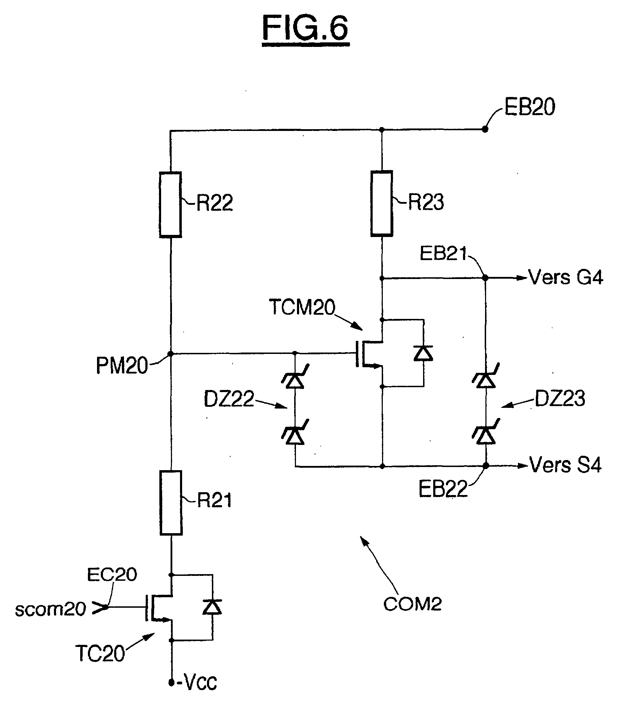

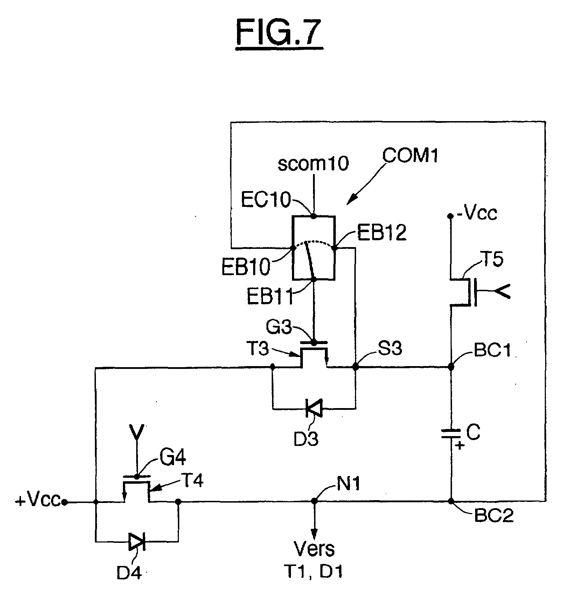

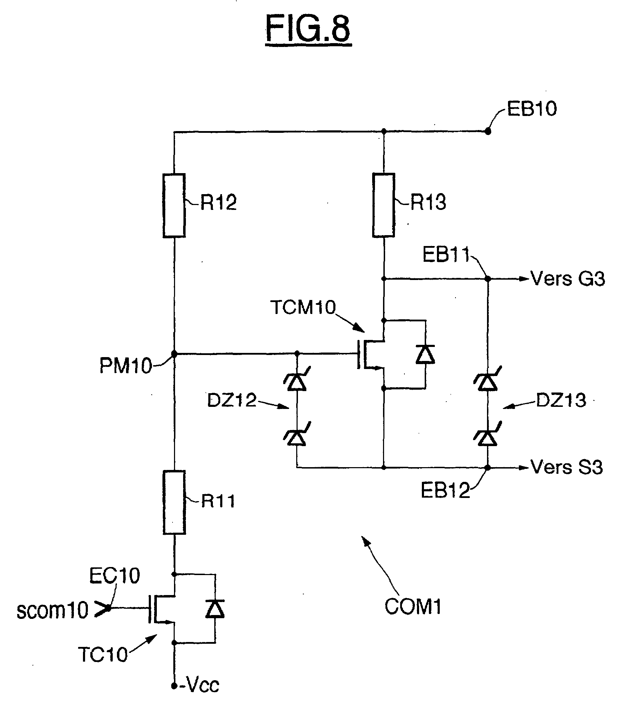

Les figures 5 et 6 illustrent un mode avantageux de réalisation permettant de commander le transistor T4, tandis que les figures 7 et 8 illustrent un mode avantageux de réalisation permettant de commander le transistor T3.

Le mode de réalisation de la figure 5 est compatible avec celui illustré sur les figures 2 et 4. A des fins de simplification, on n'a représenté sur la figure 5 qu'une partie du dispositif selon l'invention et on a, à cet égard, repéré sur les figures 2, 4 et 5, le noeud N1 auquel se raccordent les parties non illustrées sur la figure 5 et illustrées sur les figures 2 et 4.

Comme illustré schématiquement sur la figure 5, il est classique dans certaines applications, lorsque la tension d'alimentation + Vcc est relativement élevée, d'utiliser un condensateur d'auto-élevation Cboot (condensateur de bootstrap en langue anglaise) pour obtenir sur la grille du transistor T1 une tension suffisamment supérieure à la tension de source du transistor T1, afin d'autoriser la conduction de ce transistor T1.

Plus précisément, ce condensateur d'auto-élévation Cboot, connecté au transistor T1, comporte une première borne BCB 1 connectée à la grille du transistor T1 par l'intermédiaire d'un inverseur IVM formé de deux transistors complémentaires (inverseur CMOS). L'entrée de l'inverseur est commandée par un signal logique issu des moyens générant les impulsions de commande de largeur modulable et la sortie de l'inverseur est reliée à la grille du transistor T1. Par ailleurs, la première borne BCB1 du condensateur d'auto-élévation est reliée à une tension de régulation Vreg par l'intermédiaire d'une diode Dr. Cette tension de régulation est par exemple égale à 12 Volts.

La deuxième borne BCB2 du condensateur d'auto-élévation est reliée à la source du transistor T1 et au filtre de lissage F.

Lorsque le transistor T2 est conducteur, le transistor T1 est bloqué et le condensateur d'auto-élévation Cboot se charge avec la tension de régulation Vreg. La tension à la source du transistor T1 est alors égale à - Vcc.

Lorsque le transistor T2 doit être bloqué et le transistor T1 doit être rendu conducteur, cette tension égale à - Vcc sur la source du transistor T1 permet de rendre celui-ci conducteur par l'impulsion de commande délivrée à l'inverseur IVM.

Lorsque le transistor T1 devient conducteur, la tension de sa source monte alors à + Vcc et la tension de grille monte à la tension Vcc + Vboot où Vboot est la tension à la borne BCB1 du condensateur d'auto-élévation. Il en résulte donc une différence de tension grille-source de l'ordre de 10 Volts, ce qui autorise la poursuite de la conduction du transistor T1.

L'invention va avantageusement utiliser l'énergie emmagasinée dans le condensateur d'auto-élévation Cboot pour rendre conducteur le transistor T4 du deuxième interrupteur bidirectionnel.

A cet effet, les moyens de contrôle comportent un commutateur commandable COM2, que l'on désigne ci-après par "deuxième commutateur" par analogie avec le vocable "deuxième interrupteur bidirectionnel" auquel il est associé.

Ce deuxième commutateur COM2 comporte une borne EB20 reliée à la première borne BCB1 du condensateur d'auto-élévation par l'intermédiaire d'une diode DD2 dont l'anode est connectée à cette première borne BCB1 du condensateur d'auto-élévation.

Le commutateur COM2 comporte également une borne EB21 reliée à la grille G4 du transistor T4 du deuxième interrupteur bidirectionnel, et une borne EB22 reliée à la source S4 de ce transistor T4. Le commutateur COM2 possède par ailleurs une entrée de commande EC20 recevant un signal logique de commande scom20.

Ce signal logique de commande scom20 permet aux moyens de contrôle de conférer au commutateur COM2 un premier état dans lequel le commutateur COM2 relie ensemble la grille G4 et la source S4 du transistor T4, et un deuxième état dans lequel le commutateur COM2 relie la grille G4 du transistor T4 à la cathode de la diode DD2, et par conséquent à la première borne BCB1 du condensateur d'auto-élévation.

Comme on va le voir plus en détail ci-après, le deuxième état du commutateur COM2 (bornes EB20 et EB21 reliées) permet de rendre conducteur le transistor T4, tandis que le premier état du commutateur COM2 (bornes EB22 et EB21 reliées) permet de relier la grille et la source du transistor T4 et par conséquent de bloquer le transistor T4.

Si l'on se réfère maintenant plus particulièrement à la figure 6, on voit que ce deuxième commutateur commandable COM2 comporte un transistor TMC20, que l'on dénomme ici "transistor de commutation", connecté entre la grille G4 et la source S4 du transistor T4. Plus précisément, le drain du transistor TMC20 est relié à la borne EB21 et la source du transistor TMC20 est reliée à la borne EB22. Une diode est montée en antiparallèle aux bornes du transistor TMC20. Par ailleurs, deux diodes Zener DZ23 sont également montées en série entre les bornes EB21 et EB22 du commutateur COM2.

Deux autres diodes Zener DZ22 sont également connectées en série entre la source et la grille du transistor de commutation TMC20. L'anode de la première de ces deux diodes Zener DZ22 est reliée à la source du transistor TMC20, tandis que la cathode de la deuxième de ces deux diodes Zener DZ22 est reliée à la grille du transistor de commutation TMC20.

Le commutateur COM2 comporte par ailleurs un pont diviseur résistif R21 et R22 connecté en série avec un transistor de commande TC20 entre la borne EB20, c'est-à-dire la cathode de la diode DD2, et la deuxième borne (ici - Vcc) de l'alimentation principale. Plus précisément, la première résistance R21 de ce pont résistif est connectée entre le point milieu PM20 du pont diviseur et le drain du transistor de commande TC20.

La deuxième résistance R22 de ce pont diviseur est connectée entre le point milieu PM20 et la borne EB20.

Alors que la source du transistor de commande TC20 est reliée à la deuxième borne - Vcc de l'alimentation principale, la grille de ce transistor de commande constitue l'entrée de commande EC20 du commutateur CM2. Par ailleurs, une diode est également montée en antiparallèle aux bornes de ce transistor de commande TC20.

Enfin, la grille G4 du transistor T4 est connectée à la cathode de la diode DD2 par l'intermédiaire d'un moyen de limitation du courant formé ici d'une résistance R23 disposée entre les bornes EB21 et EB20. A titre indicatif, cette résistance de limitation de courant pourrait être remplacée par un inverseur CMOS.

Pendant le balayage vertical du spot, les moyens de contrôle confèrent la valeur logique "1" au signal de commande scom20 (par exemple en appliquant une tension de 5 Volts sur la grille du transistor TC20), ce transistor TC20 est donc passant. La grille du transistor de commutation TCM20 voit donc son potentiel "tiré" vers le bas, c'est-à-dire vers la tension - Vcc par l'intermédiaire du transistor de commande TC20. Le transistor TCM20 devient alors bloqué, ce qui permet de faire monter le potentiel de la grille G4 du transistor T4 à la tension de la cathode de la diode DD2 par l'intermédiaire de la résistance R23.

Et, en raison de l'existence de la capacité grille-source du transistor T4 qui va se charger progressivement lors des périodes successives de conduction du transistor T1, la tension à la grille G4 du transistor T4 va monter progressivement jusqu'à atteindre la tension Vboot (à la tension de seuil près de la diode DD2). Le transistor T4 va donc devenir conducteur.

Il convient de noter ici que, alors que la mise en conduction du transistor T4 est commandée dès le début du balayage vertical du spot, la conduction effective de ce transistor ne s'effectue pas immédiatement compte tenu de la présence de la capacité grille-source de ce transistor.

Cependant, ceci n'est pas gênant car, comme expliqué ci-avant, il est en toute rigueur nécessaire que le transistor T4 soit conducteur pendant la deuxième phase du balayage vertical (courant rentrant). Si l'on considère que la période de balayage est de 20 ms, le transistor T4 a donc 10 ms pour devenir conducteur, ce qui est largement suffisant.

La résistance R23 évite une décharge trop brutale du condensateur d'auto-élévation et limite par conséquent le courant dans la diode DD2.

Par ailleurs, pour garantir que la grille du transistor de commutation TCM20 soit suffisamment tirée vers le bas pour bloquer ce transistor, par exemple pour qu'elle atteigne un potentiel se situant à 2 Vbe (Vbe étant la tension de seuil base-émetteur d'un transistor bipolaire ou la tension de seuil en inverse d'une diode) en dessous de la tension d'alimentation + Vcc, il est particulièrement avantageux de choisir le rapport R21/(R21 + R22) inférieur ou égal à 0,4 (en théorie, le rapport R21/(R21 + R22) est choisi inférieur à (2 Vcc - 2 Vbe)/(2 Vcc + Vboot - Vbe)).

On choisira ainsi par exemple une résistance R21 de 100 kΩ et une résistance R22 de 150 kΩ.

Par ailleurs, le rôle des deux diodes Zener DZ22 est d'éviter que la tension de grille du transistor TCM20 ne descende trop bas, ce qui pourrait conduire à des tensions grille-source en inverse trop importantes avec le risque de casser la grille du transistor.

Pendant le retour rapide du spot, on confère au signal de commande scom20 la valeur logique "0" en appliquant par exemple la tension - Vcc sur la grille du transistor de commande TC20. La grille du transistor de commutation TCM20 voit donc son potentiel "tiré" vers le haut grâce à la deuxième résistance R22. Le transistor de commutation TCM20 devient donc conducteur, rendant par conséquent bloqué le transistor T4.

Le rôle de cette résistance R22 est notamment d'éviter que le point milieu PM20 soit flottant, ce qui permet de maintenir une tension de grille élevée pour rendre conducteur le transistor de commutation TCM20. Ceci étant, afin de ne pas conférer une tension trop importante à la grille du transistor TCM20 pendant la période de retour rapide du spot, les deux diodes Zener DZ22 ont là encore pour fonction de limiter la valeur de cette tension de grille, par exemple à 10 Volts (deux fois 5 Volts si 5 Volts est la tension Zener en direct).

Le rôle des deux diodes Zener DZ23, bien qu'elles ne soient pas indispensables compte tenu notamment des valeurs des tensions adoptées, est de prévenir tout risque de montée brusque de la tension de grille G4 du transistor T4, notamment en dynamique. Ainsi, lorsque le transistor T4 est conducteur, les deux diodes Zener DZ23 limitent également la tension de grille à 10 Volts (deux fois 5 Volts).

On se réfère maintenant plus particulièrement aux figures 7 et 8 pour illustrer une commande avantageuse du transistor T3 du premier interrupteur bidirectionnel, en utilisant l'énergie emmagasinée dans le condensateur auxiliaire C (condensateur de flyback).

Les moyens de contrôle comportent un premier commutateur commandable COM1 (le terme "premier" est ici là encore utilisé par analogie à l'expression "premier interrupteur bidirectionnel"). Ce commutateur commandable COM1 est relié aux deux bornes du condensateur auxiliaire C ainsi qu'à la grille G3 du transistor T3 du premier interrupteur bidirectionnel.

Plus précisément, le commutateur COM1 comporte une entrée de commande EC10 recevant un signal de commande scom10 émis par les moyens de contrôle. Il comporte également une première borne EB10 reliée à la deuxième borne BC2 du condensateur auxiliaire C. Une autre borne EB11 du commutateur COM1 est reliée à la grille G3 du transistor T3 et une troisième borne EB12 du commutateur COM1 est reliée à la source S3 du transistor T3.

Le signal de commande scom10 permet de conférer au commutateur COM1 un premier état dans lequel ce premier commutateur COM1 relie ensemble la grille G3 et la source S3 du transistor T3 (bornes EB11 et EB12 reliées), et un deuxième état dans lequel le commutateur relie la grille G3 du transistor T3 à la deuxième borne BC2 du condensateur auxiliaire C (bornes EB11 et EB10 reliées).

Dans le premier état, le transistor T3 est bloqué, tandis qu'il est mis en conduction dans le deuxième état du commutateur COM1.

La figure 8 illustre plus en détail l'architecture interne du premier commutateur COM1. Cette architecture est similaire à celle du deuxième commutateur COM2.

Plus précisément, le commutateur COM1 comporte un transistor de commutation TCM10 connecté entre la grille G3 et la source S3 du transistor T3, ainsi qu'un pont diviseur résistif R11, R12 connecté en série avec un transistor de commande TC10 entre la borne EB10 (c'est-à-dire la deuxième borne BC2 du condensateur auxiliaire) et la deuxième borne - Vcc de l'alimentation principale. La grille G3 du transistor T3 est connectée à la deuxième borne BC2 du condensateur auxiliaire par l'intermédiaire d'un moyen de limitation du courant R13 formé ici d'une résistance R13 connectée entre les bornes EB11 et EB10. Là encore, cette résistance R13 pourrait être remplacée par un inverseur CMOS.

Enfin, la grille du transistor de commutation TCM10 est reliée au point milieu PM10 du pont diviseur résistif R11, R12.

L'entrée de commande EC10 du commutateur CM1 est formée par la grille du transistor de commande TC10. Lors du balayage vertical du spot, les moyens de contrôle confèrent la valeur logique "0" au signal de commande scom10 bloquant le transistor de commande TC10. Par conséquent, la grille du transistor de commutation TCM10 voit son potentiel "tiré" vers le haut grâce à la résistance R12.

Le transistor de commutation TCM10 devient donc conducteur, reliant par conséquent la grille et la source du transistor T3 et bloquant par conséquent ce transistor T3. Là encore, d'une façon analogue à ce qui a été décrit ci-avant pour le commutateur COM2, les deux diodes Zener DZ 12 permettent de limiter la tension sur la grille du transistor TCM10 à deux tensions de Zener, soit deux fois 5 Volts par exemple.

Lors du retour rapide du spot, le signal de commande scom10 prend la valeur logique " 1", rendant conducteur le transistor de commande TC10. La tension de la grille du transistor de commutation TCM10 est donc instantanément tirée vers le bas dans le but de bloquer le transistor TCM10 et par conséquent de rendre conducteur le transistor T3. Cependant, si la tension de la grille du transistor TCM10 descend trop bas, le transistor TCM10 devient bloqué et la grille G3 du transistor T3 peut commencer à se charger alors que le transistor T4 du deuxième interrupteur bidirectionnel n'est pas encore bloqué. Dans ce cas, il peut résulter une conduction simultanée des deux transistors T3 et T4, ce qui va décharger le condensateur auxiliaire C dans l'alimentation principale, provoquant alors un fort courant non contrôlé, ce qui peut être gênant dans certaines applications. Afin de remédier à cet inconvénient, l'invention prévoit de laisser le transistor de commutation TCM10 légèrement conducteur avec une tension de grille plus faible jusqu'à ce que le transistor T4 soit bloqué.

A cet égard, on choisit le rapport K= R11/(R11 + R12) supérieur à Vz/2Vcc.

Si l'on choisit une tension Zener Vz égale à 5 Volts et une tension minimale d'alimentation égale à 9 Volts, on obtient un rapport K qui doit être supérieur à 5/18. On choisit donc de préférence un rapport K supérieur à 0,25.

Par ailleurs, lorsque le transistor T4 est bloqué, la tension de source du transistor T3 monte alors à + Vcc. Et, pour s'assurer que le transistor de commutation TCM10 se bloque pour que le transistor T3 devienne conducteur, on choisit de préférence un rapport K inférieur à 1/2, ce qui permet d'obtenir une tension de grille du transistor TCM10 égale à Vcc - 2 Vbe (pour obtenir ceci, il convient en théorie que ce rapport K soit inférieur à (2 Vcc - 2 Vbe)/4 Vcc).

Et, puisque le transistor TCM10 est bloqué, la tension de grille du transistor T3 augmente grâce à la résistance R13, ce qui rend le transistor T3 conducteur.

Là encore, les diodes Zener DZ12 ont notamment pour fonction de ne pas faire descendre la tension de grille du transistor TCM10 trop bas.

Par ailleurs, les diodes Zener DZ13 ont pour rôle de limiter la tension de la grille G3 du transistor T3 à deux fois 5 Volts. En effet, en l'absence de ces diodes Zener, la tension de grille pourrait monter jusqu'à +2Vcc (26 Volts par exemple si + Vcc = 13 Volts) compte tenu de l'énergie emmagasinée dans le condensateur auxiliaire C et de la tension d'alimentation.

Là encore, l'homme du métier aura noté que le transistor T3 n'est pas tout de suite conducteur au début du retour rapide du spot. Cependant, ceci n'est pas gênant en raison, d'une part de la présence de la diode D3, et d'autre part parce que le courant n'est rentrant dans le circuit de déviation verticale que dans la deuxième phase FB2 du retour rapide.

Les modes de réalisation illustrés sur les figures 5 et 6 d'une part et 7 et 8 d'autre part, peuvent être réalisés indépendamment les uns des autres. Ceci étant, il est particulièrement avantageux de combiner le mode de réalisation illustré sur les figures 7 et 8 avec celui ilustré sur les figures 5 et 6.

L'homme du métier aura noté que ces modes de réalisation permettent la commande des transistors T3 et T4 avec des signaux logiques classiques basse tension, notamment des signaux de 5 Volts. Dans toutes les variantes qui viennent d'être décrites, l'étage de sortie ETS, les moyens MFB et le filtre F peuvent être aisément réalisés au sein d'un même circuit intégré.

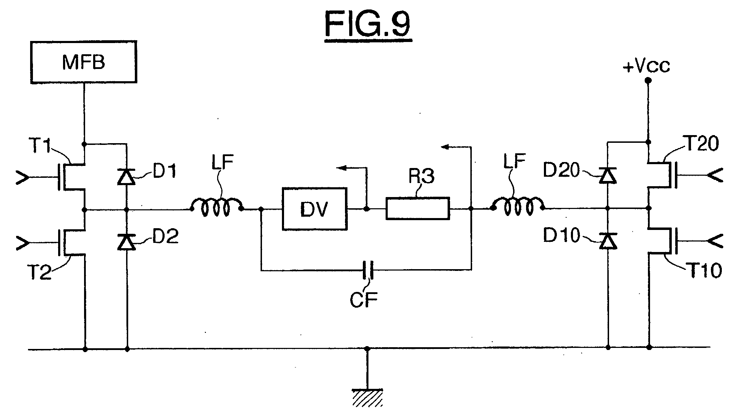

La figure 9 illustre schématiquement une variante de réalisation de l'étage de sortie en pont complet. Plus précisément, selon cette variante, on adjoint aux premiers transistors T1 et T2 deux autres transistors T10 et T20 associés à deux diodes D10 et D20 montées en anti-parallèle. Les transistors T1, T2, T10 et T20 sont alimentés entre + Vcc et la masse. Les transistors T1 et T10 sont commandés simultanément et les transistors T2 et T20 sont commandés simultanément. Bien entendu, les moyens MFB ne sont reliés qu'à une des deux paires de transistors, en l'espèce par exemple les transistors T1 et T2. Le filtre de lissage se compose alors de deux inductances LF, respectivement connectées aux bornes communes des deux transistors de chaque paire. Le déviateur et la résistance R3 sont connectés en série entre les deux inductances LF, et la capacité CF du filtre F est montée en parallèle aux bornes du déviateur DV et de la résistance R3. La boucle de contre-réaction est ici réalisée de façon différentielle comme indiqué très schématiquement par les deux flèches aux bornes de la résistance R3.

## Revendications

1. Procédé de commande d'un circuit de déviation verticale d'un spot balayant un écran, dans lequel on commande le balayage vertical du spot par l'intermédiaire d'un étage amplificateur de sortie (ETS) alimenté par une alimentation principale, et on commande le retour rapide du spot en délivrant au circuit de déviation verticale une surtension produite par une alimentation auxiliaire (ALM), **caractérisé par le fait que** l'étage de sortie (ETS) est un étage à au moins deux transistors (T1, T2) que l'on fait fonctionner en classe D au moins pour la commande du balayage vertical du spot, **par le fait qu'**on délivre ladite surtension en commandant un premier interrupteur bidirectionnel (T3, D3) connecté à l'étage de sortie et à l'alimentation auxiliaire (ALM) de façon à autoriser la circulation d'un courant à travers ce premier interrupteur, et **par le fait qu'**on commande un deuxième interrupteur bidirectionnel (T4, D4) connecté entre un premier transistor (T1) de l'étage de sortie et une première borne (+ Vcc) de l'alimentation principale de façon à empêcher la circulation d'un courant à travers le premier interrupteur pendant le balayage vertical du spot et empêcher ainsi la délivrance de ladite surtension pendant le balayage vertical du spot.

2. Procédé selon la revendication 1, **caractérisé par le fait que** le premier interrupteur bidirectionnel comporte un transistor (T3) et une diode (D3) montée en anti-parallèle aux bornes du transistor (T3), dont l'anode est reliée au premier transistor (T1) de l'étage de sortie, **par le fait que** le deuxième interrupteur bidirectionnel comporte un transistor (T4) connecté en série entre le premier transistor (T1) de l'étage de sortie et la première borne (+ Vcc) de l'alimentation principale, et une diode (D4) montée en anti-parallèle aux bornes du transistor (T4), dont la cathode est reliée audit premier transistor (T1) de l'étage de sortie et dont l'anode est reliée à ladite première borne (+ Vcc) de l'alimentation principale, **par le fait que** le balayage vertical du spot comporte une première phase (B 1) dans laquelle le courant est rentrant dans le circuit de déviation verticale et une deuxième phase (B2) dans laquelle le courant est sortant vis-à-vis du circuit de déviation verticale, **par le fait que** le retour rapide du spot comporte une première phase (FB1) dans laquelle le courant est sortant vis-à-vis du circuit de déviation verticale et une deuxième phase (FB2) dans laquelle le courant est rentrant dans le circuit de déviation verticale, **par le fait qu'**on bloque le transistor (T3) du premier interrupteur bidirectionnel pendant le balayage vertical tandis qu'on commande le deuxième interrupteur bidirectionnel en rendant conducteur le transistor (T4) de ce deuxième interrupteur bidirectionnel au moins lorsque le deuxième transistor (T2) de l'étage de sortie est bloqué pendant la deuxième phase (B2) du balayage vertical, et **par le fait qu'**on bloque le transistor (T4) du deuxième interrupteur bidirectionnel pendant le retour rapide du spot tandis qu'on rend conducteur le transistor (T3) du premier interrupteur bidirectionnel au moins pendant la deuxième phase du retour rapide (FB2).

3. Procédé selon la revendication 2, **caractérisé par le fait qu'**on commande la mise en conduction du transistor (T4) du deuxième interrupteur bidirectionnel dès le début du balayage vertical du spot, et **par le fait que** pendant le retour rapide du spot, on rend conducteur le transistor (T3) du premier interrupteur bidirectionnel dès que le transistor du deuxième interrupteur bidirectionnel a été bloqué.

4. Procédé selon l'une des revendications 2 ou 3, **caractérisé par le fait que** le premier interrupteur bidirectionnel (T3, D3) est connecté en série entre l'alimentation auxiliaire (ALM) et le premier transistor (T1) de l'étage de sortie.

5. Procédé selon l'une des revendications 2 ou 3, **caractérisé par le fait que** l'alimentation auxiliaire comporte un condensateur auxiliaire(C) dont une première borne est reliée d'une part à la première borne (+ Vcc) de l'alimentation principale par l'intermédiaire du premier interrupteur bidirectionnel (T3, D3) et d'autre part à une deuxième borne (- Vcc) de l'alimentation principale par l'intermédiaire d'un interrupteur auxiliaire commandable (T5), **par le fait que** la deuxième borne du condensateur auxiliaire est reliée à l'étage de sortie et au deuxième interrupteur bidirectionnel (T4, D4), et **par le fait que** l'interrupteur auxiliaire (T5) est ouvert lorsque le transistor du premier interrupteur bidirectionnel (T3, D3) est conducteur et vice versa.

6. Procédé selon la revendication 5, **caractérisé par le fait que** pendant le balayage vertical du spot, on ferme l'interrupteur auxiliaire (T5), et **par le fait que** pendant le retour rapide du spot, on ouvre l'interrupteur auxiliaire (T5).

7. Procédé selon la revendication 5 ou 6, **caractérisé par le fait que** le transistor du premier interrupteur bidirectionnel est connecté entre la première borne du condensateur auxiliaire (C) et la première borne (+ Vcc) de l'alimentation principale, et **par le fait qu'**on utilise l'énergie emmagasinée dans le condensateur auxiliaire pour rendre conducteur le transistor (T3) du premier interrupteur bidirectionnel.

8. Procédé selon la revendication 7, **caractérisé par le fait qu'**on connecte la grille du transistor (T3) du premier interrupteur bidirectionnel à la première borne du condensateur auxiliaire pour rendre conducteur ce transistor, et **par le fait qu'**on connecte la grille du transistor (T3) du premier interrupteur bidirectionnel à sa source pour bloquer ce transistor.

9. Procédé selon l'une des revendications 2 à 8 prise en combinaison avec la revendication 3, **caractérisé par le fait qu'**un condensateur d'auto-élévation (Cboot) est connecté entre la source et la grille du premier transistor (T1) de l'étage de sortie, et **par le fait qu'**on utilise l'énergie emmagasinée dans le condensateur d'auto-élévation pour rendre conducteur le transistor (T4) du deuxième interrupteur bidirectionnel pendant le balayage vertical du spot.

10. Procédé selon la revendication 9, **caractérisé par le fait qu'**on connecte le condensateur d'auto-élévation (Cboot) à la grille du transistor (T4) du deuxième interrupteur bidirectionnel pendant le balayage vertical du spot, et **par le fait qu'**on relie la grille du transistor (T4) du deuxième interrupteur bidirectionnel à sa source pendant le retour rapide du spot

11. Procédé selon l'une des revendications précédentes, **caractérisé par le fait que** pendant la phase de balayage vertical du spot, on commande les transistors (T1, T2) de l'étage de sortie en classe D compte tenu d'un signal de consigne (SC), et **par le fait que** pendant la phase de retour rapide du spot, on rend conducteur le premier transistor (T1) de l'étage de sortie.

12. Procédé selon l'une des revendications précédentes, **caractérisé par le fait que** pendant la phase de balayage vertical du spot, on commande les transistors (T1, T2) de l'étage de sortie en classe D compte tenu d'un signal de consigne (SC), **par le fait qu'**on amplifie le signal de consigne (SC) contre-réactionné par le courant (IDV) traversant le circuit de déviation, de façon à délivrer un signal d'erreur (ε), on détecte le franchissement d'un seuil prédéterminé par le signal d'erreur (ε), et on déclenche la phase de retour rapide du spot lorsque le signal d'erreur franchit ledit seuil.

13. Dispositif de commande d'un circuit de déviation verticale d'un spot balayant un écran, comprenant un étage amplificateur de sortie (ETS) alimenté par une alimentation principale pour la commande de balayage vertical du spot, une alimentation auxiliaire(ALM) capable de délivrer une surtension au circuit de déviation verticale pour un retour rapide du spot, **caractérisé par le fait que** l'étage de sortie (ETS) est un étage à au moins deux transistors (T1, T2) aptes à fonctionner en classe D au moins pour la commande de balayage vertical du spot, cet étage étant associé à un filtre de lissage (F) connecté à la borne commune (BSS) des deux transistors, **par le fait que** le dispositif comprend un premier interrupteur bidirectionnel commandable (T3, D3) connecté à l'étage de sortie et à l'alimentation auxiliaire (ALM), un deuxième interrupteur bidirectionnel commandable (T4, D4) connecté entre un premier transistor (T1) de l'étage de sortie et une première borne (+ Vcc) de l'alimentation principale, ainsi que des moyens de contrôle (PWM, COM1, COM2) aptes à commander
les transistors (T1, T2) de l'étage de sortie en classe D,
le premier interrupteur (T3, D3) de façon à autoriser la circulation d'un courant à travers ce premier interrupteur et la délivrance de ladite surtension, et
le deuxième interrupteur (T4, D4) de façon à empêcher la circulation d'un courant à travers le premier interrupteur pendant le balayage vertical du spot et empêcher ainsi la délivrance de ladite surtension pendant le balayage vertical du spot.

14. Dispositif selon la revendication 13, **caractérisé par le fait que** chaque transistor (T1, T2) de l'étage de sortie comporte une diode (D1, D2) montée en anti-parallèle à ses bornes.

15. Dispositif selon la revendication 13 ou 14, **caractérisé par le fait que** le premier interrupteur bidirectionnel comporte un transistor (T3) et une diode (D3) montée en anti-parallèle aux bornes du transistor (T3), dont l'anode est reliée au premier transistor (T1) de l'étage de sortie, **par le fait que** le deuxième interrupteur bidirectionnel comporte un transistor (T4) connecté en série entre le premier transistor (T1) de l'étage de sortie et la première borne (+ Vcc) de l'alimentation principale, et une diode (D4) montée en anti-parallèle aux bornes du transistor (T4), dont la cathode est reliée audit premier transistor (T1) de l'étage de sortie et dont l'anode est reliée à ladite première borne (+ Vcc) de l'alimentation principale.

16. Dispositif selon la revendication 15, **caractérisé par le fait que** l'alimentation auxiliaire comporte un condensateur auxiliaire (C) dont une première borne est reliée d'une part à la première borne (+ Vcc) de l'alimentation principale par l'intermédiaire du premier interrupteur bidirectionnel (T3, D3) et d'autre part à une deuxième borne (- Vcc) de l'alimentation principale par l'intermédiaire d'un interrupteur auxiliaire commandable (T5), **par le fait que** la deuxième borne du condensateur auxiliaire est reliée à l'étage de sortie et au deuxième interrupteur bidirectionnel (T4, D4).

17. Dispositif selon la revendication 16, **caractérisé par le fait que** les moyens de contrôle comportent un premier commutateur (COM1) commandable relié aux deux bornes du condensateur auxiliaire (C) et à la grille du transistor (T3) du premier interrupteur bidirectionnel, et possédant un premier état dans lequel le premier commutateur relie ensemble le grille et la source du transistor du premier interrupteur bidirectionnel, et un deuxième état dans lequel il relie la grille du transistor du premier interrupteur bidirectionnel à la deuxième borne du condensateur auxiliaire.

18. Dispositif selon la revendication 17, **caractérisé par le fait que** le premier commutateur commandable (COM1) comporte un transistor de commutation (TCM10) connecté entre la grille et la source du transistor du premier interrupteur bidirectionnel, un pont diviseur résistif connecté en série avec un transistor de commande entre la deuxième borne du condensateur auxiliaire et la deuxième borne (-Vcc) de l'alimentation principale, **par le fait que** la grille du transistor du premier interrupteur bidirectionnel est connectée à la deuxième borne du condensateur auxiliaire par l'intermédiaire d'un moyen de limitation du courant (R13), et **par le fait que** la grille du transistor de commutation est reliée au point milieu (PM10) du pont diviseur.

19. Dispositif selon la revendication 18, **caractérisé par le fait que** le pont diviseur comporte une première résistance (R11) connectée entre le point milieu et la deuxième borne de l'alimentation principale, et une deuxième résistance (R12) connectée entre le point milieu et la deuxième borne du condensateur auxiliaire, et **par le fait que** le rapport entre la valeur de cette première résistance et la somme des valeurs des deux résistances est compris entre 0,25 et 0,5.

20. Dispositif selon la revendication 15, **caractérisé par le fait que** le premier interrupteur bidirectionnel (T3, D3) est connecté en série entre l'alimentation auxiliaire (ALM) et le premier transistor (T1) de l'étage de sortie.

21. Dispositif selon l'une des revendications 13 à 20, prise en combinaison avec la revendication 15, **caractérisé par le fait que** l'étage de sortie comporte un condensateur d'auto-élévation (Cboot) connecté au premier transistor (T1) de cet étage de sortie, ledit condensateur d'auto-élévation comportant une première borne (BCB1) connectée à la grille du premier transistor de l'étage de sortie et une deuxième borne (BCB2) connectée au filtre de lissage, et **par le fait que** les moyens de contrôle comportent un deuxième commutateur commandable (COM2) relié
à la première borne du condensateur d'auto-élévation par l'intermédiaire d'une diode (DD2) dont l'anode est connectée à la première borne du condensateur d'auto-élévation, et
à la source et à la grille du transistor (T4) du deuxième interrupteur bidirectionnel,
et **par le fait que** ce deuxième commutateur posséde un premier état dans lequel le deuxième commutateur (COM2) relie ensemble la grille et la source du transistor du deuxième interrupteur bidirectionnel, et un deuxième état dans lequel il relie la grille du transistor du deuxième interrupteur bidirectionnel à la cathode de ladite diode.

22. Dispositif selon la revendication 21, **caractérisé par le fait que** le deuxième commutateur commandable (COM2) comporte un transistor de commutation (TCM20) connecté entre la grille et la source du transistor (T4) du deuxième interrupteur bidirectionnel, un pont diviseur résistif connecté en série avec un transistor de commande entre la cathode de la diode (DD2) et la deuxième borne (-Vcc) de l'alimentation principale, **par le fait que** la grille du transistor du deuxième interrupteur bidirectionnel est connectée à la cathode de la diode (DD2) par l'intermédiaire d'un moyen de limitation du courant, et **par le fait que** la grille du transistor de commutation est reliée au point milieu du pont diviseur (PM20).

23. Dispositif selon la revendication 22, **caractérisé par le fait que** le pont diviseur comporte une première résistance (R21) connectée entre le point milieu et la deuxième borne de l'alimentation principale, et une deuxième résistance (R22) connectée entre le point milieu et la cathode de la diode, et **par le fait que** le rapport entre la valeur de cette première résistance et la somme des valeurs des deux résistances est inférieur à 0,4.

24. Dispositif selon l'une des revendications 13 à 23, **caractérisé par le fait que** pendant la commande de balayage vertical du spot, les moyens de contrôle commandent les transistors (T1, T2) de l'étage de sortie en classe D compte tenu d'un signal de consigne (SC) présent en entrée du dispositif, ouvrent le premier interrupteur bidirectionnel (T3, D3) et ferment le deuxième interrupteur bidirectionnel (T4, D4), et **par le fait que** pendant la commande de retour rapide du spot, les moyens de contrôle rendent conducteur le premier transistor (T1) de l'étage de sortie, ouvrent le deuxième interrupteur bidirectionnel (T4, D4) et ferment le premier interrupteur.

25. Dispositif selon les revendications 16 et 24, **caractérisé par le fait que** pendant la commande de balayage vertical du spot, les moyens de contrôle ferment l'interrupteur auxiliaire (T5), et **par le fait que** pendant la commande de retour rapide du spot, les moyens de contrôle ouvrent l'interrupteur auxiliaire (T5).

26. Dispositif selon la revendication 24 ou 25, **caractérisé par le fait qu'**il comprend un étage de pré-amplification (PMP) recevant le signal de consigne (SC) contre-réactionné par le courant (IDV) traversant le circuit de déviation, et délivrant un signal d'erreur (ε), et **par le fait qu'**il comprend en outre des moyens de détection (DTF) aptes à détecter le franchissement d'un seuil prédéterminé par le signal d'erreur (ε), et **par le fait que** les moyens de contrôle déclenchent la phase de retour rapide du spot lorsque le signal d'erreur franchit ledit seuil.

27. Dispositif selon l'une des revendications 13 à 26, **caractérisé par le fait que** l'étage de sortie (ETS) comporte deux autres transistors (T10, T20) aptes à fonctionner en classe D au moins pour la commande de balayage vertical du spot, les quatre transistors formant un montage en pont complet, et **par le fait que** le filtre de lissage (F) est connecté entre la borne commune des deux premiers transistors et la borne commune des deux autres transistors, et se répartit de part et d'autre du circuit de déviation.

28. Dispositif selon l'une des revendications 13 à 27, **caractérisé par le fait que** tous les transistors sont des transitors à effet de champ à grille isolée, avec la source reliée au substrat de façon à former la diode associée montée en anti-parallèle, et **par le fait qu'**il est réalisé sous la forme d'un circuit intégré.

29. Téléviseur comprenant un écran, un circuit de déviation verticale d'un spot balayant ledit écran et un dispositif de commande du circuit de déviation verticale, **caractérisé par le fait que** le dispositif de commande du circuit de déviation verticale est un dispositif selon l'une des revendications 13 à 28.

30. Moniteur informatique comprenant un écran, un circuit de déviation verticale d'un spot balayant ledit écran et un dispositif de commande du circuit de déviation verticale, **caractérisé par le fait que** le dispositif de commande du circuit de déviation verticale est un dispositif selon l'une des revendications 13 à 28.

## Claims

1. Method for controlling a circuit for the vertical deflection of a spot scanning a screen, in which the vertical scan of the spot is controlled by means of an output amplifier stage (ETS) supplied by a main supply and the flyback of the spot is initiated by delivering an overvoltage, produced by an auxiliary supply (ALM), to the vertical deflection circuit, **characterized in that** the output stage (ETS) is a stage comprising at least two transistors (T1, T2) which are made to operate in Class-D operation at least for controlling the vertical scan of the spot, **in that** the said overvoltage is delivered by controlling a first two-way switch (T3, D3) connected to the output stage and to the auxiliary supply (ALM) so as to allow a current to flow through this first switch and **in that** a second two-way switch (T4, D4), connected between a first transistor (T1) of the output stage and a first terminal (+Vcc) of the main supply, is controlled so as to prevent a current from flowing through the first switch during the vertical scan of the spot and thus prevent the said overvoltage being delivered during the vertical scan of the spot.

2. Method according to Claim 1, **characterized in that** the first two-way switch comprises a transistor (T3) and a diode (D3) connected in antiparallel with the terminals of the transistor (T3), the anode of which is connected to the first transistor (T1) of the output stage, **in that** the second two-way switch comprises a transistor (T4) connected in series between the first transistor (T1) of the output stage and the first terminal (+Vcc) of the main supply, and a diode (D4) connected in antiparallel with the terminals of the transistor (T4), the cathode of which is connected to the said first transistor (T1) of the output stage and the anode of which is connected to the said first terminal (+Vcc) of the main supply, **in that** the vertical scan of the spot comprises a first phase (B1) during which the current flows into the vertical deflection circuit and a second phase (B2) during which the current flows from the vertical deflection circuit, **in that** the flyback of the spot comprises a first phase (FB1) during which the current flows from the vertical deflection circuit and a second phase (FB2) during which the current flows into the vertical deflection circuit, **in that** the transistor (T3) of the first two-way switch is turned off during the vertical scan, while the second two-way switch is controlled so as to turn the transistor (T4) of this second two-way switch on, at least when the second transistor (T2) of the output stage is off during the second phase (B2) of the vertical scan, and **in that** the transistor (T4) of the second two-way switch is off during the flyback of the spot whereas the transistor (T3) of the first two-way switch is turned on, at least during the second phase (FB2) of the flyback.

3. Method according to Claim 2, **characterized in that** the operation of turning the transistor (T4) of the second two-way switch on is initiated right from the start of the vertical scan of the spot and **in that**, during the flyback of the spot, the transistor (T3) of the first two-way switch is turned on as soon as the transistor of the second two-way switch has been turned off.

4. Method according to either of Claims 2 and 3, **characterized in that** the first two-way switch (T3, D3) is connected in series between the auxiliary supply (ALM) and the first transistor (T1) of the output stage.

5. Method according to either of Claims 2 and 3, **characterized in that** the auxiliary supply comprises an auxiliary capacitor (C), a first terminal of which is connected on the one hand to the first terminal (+Vcc) of the main supply via the first two-way switch (T3, D3) and on the other hand to a second terminal (-Vcc) of the main supply via a controllable auxiliary switch (T5), **in that** the second terminal of the auxiliary capacitor is connected to the output stage and to the second two-ways switch (T4, D4) and **in that** the auxiliary switch (T5) is open when the transistor of the first two-way switch (T3, D3) is on and vice versa.

6. Method according to Claim 5, **characterized in that** the auxiliary switch (T5) is closed during the vertical scan of the spot and **in that** the auxiliary switch (T5) is open during the flyback of the spot.

7. Method according to Claim 5 or 6, **characterized in that** the transistor of the first two-way switch is connected between the first terminal of the auxiliary capacitor (C) and the first terminal (+Vcc) of the main supply and **in that** the energy stored in the auxiliary capacitor is used to turn on the transistor (T3) of the first two-way switch.

8. Method according to Claim 7, **characterized in that** the gate of the transistor (T3) of the first two-way switch is connected to the first terminal of the auxiliary capacitor in order to turn this transistor on and **in that** the gate of the transistor (T3) of the first two-way switch is connected to its source in order to turn this transistor off.

9. Method according to one of Claims 2 to 8 taken in combination with Claim 3, **characterized in that** a bootstrap capacitor (Cboot) is connected between the source and the gate of the first transistor (T1) of the output stage and **in that** the energy stored in the bootstrap capacitor is used to turn on the transistor (T4) of the second two-way switch during the vertical scan of the spot.

10. Method according to Claim 9, **characterized in that** the bootstrap capacitor (Cboot) is connected to the gate of the transistor (T4) of the second two-way switch during the vertical scan of the spot and **in that** the gate of the transistor (T4) of the second two-way switch is connected to its source during the flyback of the spot.

11. Method according to one of the preceding claims, **characterized in that** the transistors (T1, T2) of the output stage are controlled in Class-D operation on the basis of a reference signal (SC) during the vertical scan phase of the spot and **in that** the first transistor (T1) of the output stage is turned on during the flyback phase of the spot.

12. Method according to one of the preceding claims, **characterized in that** the transistors (T1, T2) of the output stage are controlled in Class-D operation on the basis of a reference signal (SC) during the vertical scan phase of the spot, **in that** the reference signal (SC) feedback-modified by the current (IDV) flowing through the deflection circuit is amplified, so as to deliver an error signal (ε), **in that** the point when the error signal (ε) crosses a predetermined threshold is detected and **in that** the flyback phase of the spot is triggered when the error signal crosses the said threshold.

13. Device for controlling a circuit for the vertical deflection of a spot scanning a screen, which comprises an output amplifier stage (ETS) supplied by a main supply for controlling the vertical scan of the spot, an auxiliary supply (ALM) capable of delivering an overvoltage to the vertical deflection circuit for flyback of the spot, **characterized in that** the output stage (ETS) is a stage comprising at least two transistors (T1, T2) capable of operating in Class-D operation at least for controlling the vertical scan of the spot, this stage being associated with a smoothing filter (F) connected to the common terminal (BSS) of the two transistors and **in that** the device includes a first controllable two-way switch (T3, D3) connected to the output stage and to the auxiliary supply (ALM), a second controllable two-way switch (T4, D4) connected between a first transistor (T1) of the output stage and a first terminal (+Vcc) of the main supply, and control means (PWM, COM1, COM2) capable of controlling:
the transistors (T1, T2) of the output stage in Class-D operation;
the first switch (T3, D3) so as to allow a current to flow through this first switch and allow the said overvoltage to be delivered; and
the second switch (T4, D4) so as to prevent a current from flowing through the first switch during the vertical scan of the spot and thus prevent the said overvoltage being delivered during the vertical scan of the spot.

14. Device according to Claim 13, **characterized in that** each transistor (T1, T2) of the output stage comprises a diode (D1, D2) connected in antiparallel with its terminals.

15. Device according to Claim 13 or 14, **characterized in that** the first two-way switch comprises a transistor (T3) and a diode (D3) connected in antiparallel with the terminals of the transistor (T3), the anode of which is connected to the first transistor (T1) of the output stage, **in that** the second two-way switch comprises a transistor (T4) connected in series between the first transistor (T1) of the output stage and the first terminal (+Vcc) of the main supply, and a diode (D4) connected in antiparallel with the terminals of the transistor (T4), the cathode of which is connected to the said first transistor (T1) of the output stage and the anode of which is connected to the said first terminal (+Vcc) of the main supply.

16. Device according to Claim 15, **characterized in that** the auxiliary supply comprises an auxiliary capacitor (C), a first terminal of which is connected on the one hand to the first terminal (+Vcc) of the main supply via the first two-way switch (T3, D3) and on the other hand to a second terminal (-Vcc) of the main supply via a controllable auxiliary switch (T5) and **in that** the second terminal of the auxiliary capacitor is connected to the output stage and to the second two-way switch (T4, D4).

17. Device according to Claim 16, **characterized in that** the control means comprise a first controllable switch (COM1) connected to the two terminals of the auxiliary capacitor (C) and to the gate of the transistor (T3) of the first two-way switch, and possessing a first state in which the first switch connects the gate and the source of the transistor of the first two-way switch together and a second state in which it connects the gate of the transistor of the first two-way switch to the second terminal of the auxiliary capacitor.

18. Device according to Claim 17, **characterized in that** the first controllable switch (COM1) comprises a switching transistor (TCM10) connected between the gate and the source of the transistor of the first two-way switch, a resistive divider bridge connected in series with a control transistor between the second terminal of the auxiliary capacitor and the second terminal (-Vcc) of the main supply, **in that** the gate of the transistor of the first two-way switch is connected to the second terminal of the auxiliary capacitor via a current-limiting means (R13) and **in that** the gate of the switching transistor is connected to the mid-point (PM10) of the divider bridge.

19. Device according to Claim 18, **characterized in that** the divider bridge comprises a first resistor (R11) connected between the mid-point and the second terminal of the main supply, and a second resistor (R12) connected between the mid-point and the second terminal of the auxiliary capacitor, and **in that** the ratio of the resistance value of this first resistor to the sum of the resistance values of the two resistors is between 0.25 and 0.5.

20. Device according to Claim 15, **characterized in that** the first two-way switch (T3, D3) is connected in series between the auxiliary supply (ALM) and the first transistor (T1) of the output stage.

21. Device according to one of Claims 13 to 20, taken in combination with Claim 15, **characterized in that** the output stage comprises a bootstrap capacitor (Cboot) connected to the first transistor (T1) of this output stage, the said bootstrap capacitor comprising a first terminal (BCB1) connected to the gate of the first transistor of the output stage and a second terminal (BCB2) connected to the smoothing filter, and **in that** the control means comprise a second controllable switch (COM2) connected:
to the first terminal of the bootstrap capacitor via a diode (DD2), the anode of which is connected to the first terminal of the bootstrap capacitor; and
to the source and to the gate of the transistor (T4) of the second two-way switch;
and **in that** this second switch has a first state in which the second switch (COM2) connects the gate and the source of the transistor of the second two-way switch together, and a second state in which it connects the gate of the transistor of the second two-way switch to the cathode of the said diode.

22. Device according to Claim 21, **characterized in that** the second controllable switch (COM2) comprises a switching transistor (TCM20) connected between the gate and the source of the transistor (T4) of the second two-way switch, a resistive divider bridge connected in series with a control transistor between the cathode of the diode (DD2) and the second terminal (-Vcc) of the main supply, **in that** the gate of the transistor of the second two-way switch is connected to the cathode of the diode (DD2) via a current-limiting means and **in that** the gate of the switching transistor is connected to the mid-point of the divider bridge (PM20).

23. Device according to Claim 22, **characterized in that** the divider bridge comprises a first resistor (R21) connected between the mid-point and the second terminal of the main supply, and a second resistor (R22) connected between the mid-point and the cathode of the diode and **in that** the ratio between the resistance value of this first resistor and the sum of the resistance values of the two resistors is less than 0.4.

24. Device according to one of Claims 13 to 23, **characterized in that**, during the control of the vertical scan of the spot, the control means control the transistors (T1, T2) of the output stage in Class-D operation on the basis of a reference signal (SC) present as input to the device, open the first two-way switch (T3, D3) and close the second two-way switch (T4, D4) and **in that** during the control of the flyback of the spot, the control means turn the first transistor (T1) of the output stage on, open the second two-way switch (T4, D4) and close the first switch.

25. Device according to Claims 16 and 24, **characterized in that**, during control of the vertical scan of the spot, the control means close the auxiliary switch (T5) and **in that**, during control of the flyback of the spot, the control means open the auxiliary switch (T5).

26. Device according to Claim 24 or 25, **characterized in that** it includes a preamplification stage (PMP) which receives the reference input signal (SC) feedback-modified by the current (IDV) passing through the deflection circuit and delivering an error signal (ε), **in that** it furthermore includes detection means (DTF) capable of detecting when the error signal (ε) crosses a predetermined threshold and **in that** the control means trigger the flyback phase of the spot when the error signal crosses the said threshold.

27. Device according to one of Claims 13 to 26, **characterized in that** the output stage (ETS) comprises two other transistors (T10, T20) capable of operating in Class-D operation at least for controlling the vertical scan of the spot, the four transistors forming a complete bridge arrangement, and **in that** the smoothing filter (F) is connected between the common terminal of the first two transistors and the common terminal of the other two transistors, the said smoothing filter being distributed on either side of the deflection circuit.

28. Device according to one of Claims 13 to 27, **characterized in that** all the transistors are isolated-gate-field-effect transistors with the source connected to the substrate so as to form the associated diode connected in antiparallel and **in that** it is produced in the form of an integrated circuit.

29. Television set, which includes a screen, a circuit for the vertical deflection of a spot scanning the said screen and a device for controlling the vertical deflection circuit, **characterized in that** the device for controlling the vertical deflection circuit is a device according to one of Claims 13 to 28.

30. Computer monitor, which includes a screen, a circuit for the vertical deflection of a spot scanning the said screen and a device for controlling the vertical deflection circuit, **characterized in that** the device for controlling the vertical deflection circuit is a device according to one of Claims 13 to 28.

## Patentansprüche

1. Verfahren zur Steuerung einer Schaltung zur vertikalen Ablenkung (vertikale Ablenkschaltung) eines einen Bildschirm abtastenden Punkts, wobei die vertikale Abtastung des Punkts über eine Ausgangsverstärkerstufe (ETS) gesteuert wird, die von einer Hauptversorgung gespeist wird, und der schnelle Rücklauf des Punkts dadurch gesteuert wird, daß der vertikalen Ablenkschaltung eine Überspannung zugeführt wird, die von einer Hilfsversorgung (ALM) erzeugt wird,
**dadurch gekennzeichnet,**
**daß** die Ausgangsstufe (ETS) eine Stufe mit mindestens zwei Transistoren (T1,T2) ist, die zumindest für die Steuerung der vertikalen Abtastung des Punkts in einem D-Betrieb betrieben werden,
**daß** die Überspannung ausgegeben wird, indem ein erster Zweirichtungsschalter (T3,D3), der mit der Ausgangsstufe und der Hilfsversorgung (ALM) verbunden ist, so gesteuert wird, um einen Stromfluß über diesen ersten Schalter zu erlauben, und
**daß** ein zweiter Zweirichtungsschalter (T4,D4), der zwischen einem ersten Transistor (T1) der Ausgangsstufe und einem ersten Anschluß (+Vcc) der Hauptversorgung angeordnet ist, so gesteuert wird, um während der vertikalen Abtastung des Punkts einen Stromfluß über den ersten Schalter zu verhindern und somit während der vertikalen Abtastung des Punkts die Abgabe der Überspannung zu verhindern.

2. Verfahren nach Anspruch 1, **dadurch gekennzeichnet,**
**daß** der erste Zweirichtungsschalter einen Transistor (T3) und eine antiparallel zu den Anschlüssen des Transistors (T3) angeordnete Diode (D3) aufweist, deren Anode mit dem ersten Transistor (T1) der Ausgangsstufe verbunden ist,
**daß** der zweite Zweirichtungsschalter einen Transistor (T4), der seriell zwischen dem ersten Transistor (T1) der Ausgangsstufe und dem ersten Anschluß (+Vcc) der Hauptversorgung angeordnet ist, und eine antiparallel zu den Anschlüssen des Transistors (T4) angeordnete Diode (D4) aufweist, deren Kathode mit dem ersten Transistor (T1) der Ausgangsstufe verbunden ist und deren Anode mit dem ersten Anschluß (+Vcc) der Hauptversorgung verbunden ist,
**daß** die vertikale Abtastung des Punkts eine erste Phase (B1), in welcher der Strom in die vertikale Ablenkschaltung zurückfließt, und eine zweite Phase (B2) aufweist, in welcher der Strom aus der vertikale Ablenkungsschaltung herausfließt,
**daß** der schnelle Rücklauf des Punkts eine erste Phase (FB1), in welcher der Strom aus der vertikalen Ablenkschaltung herausfließt, und eine zweite Phase (FB2) aufweist, in welcher der Strom in die vertikale Ablenkschaltung zurückfließt,
**daß** der Transistor (T3) des ersten Zweirichtungsschalters während der vertikalen Abtastung gesperrt ist, wohingegen der zweite Zweirichtungsschalter so gesteuert wird, daß der Transistor (T4) dieses zweiten Zweirichtungsschalters mindestens dann leitend ist, wenn der zweite Transistor (T2) der Ausgangsstufe während der zweiten Phase (B2) der vertikalen Abtastung gesperrt ist, und
**daß** der Transistor (T4) des zweiten Zweirichtungsschalters während des schnellen Rücklaufs des Punkts gesperrt ist, wohingegen der Transistor (T3) des ersten Zweirichtungsschalters zumindest während der zweiten Phase des schnellen Rücklaufs (FB2) leitend ist.

3. Verfahren nach Anspruch 2, **dadurch gekennzeichnet,**
**daß** das Leitendmachen (T4) des Transistors (T4) des zweiten Zweirichtungsschalters mit Beginn der vertikalen Abtastung des Punkts gesteuert wird, und
**daß** während des schnellen Rücklaufs des Punkts der Transistor (T3) des ersten Zweirichtungsschalters leitend gemacht wird, sobald der Transistor des zweiten Zweirichtungsschalters gesperrt worden ist.

4. Verfahren nach einem der Ansprüche 2 oder 3, **dadurch gekennzeichnet, daß** der erste Zweirichtungsschalter (T3,D3) seriell zwischen der Hilfsversorgung (ALM) und dem ersten Transistor (T1) der Ausgangsstufe angeordnet ist.

5. Verfahren nach einem der Ansprüche 2 oder 3, **dadurch gekennzeichnet,**
**daß** die Hilfsversorgung einen Hilfskondensator (C) aufweist, dessen erster Anschluß einerseits über den ersten Zweirichtungsschalter (T3,D3) mit dem ersten Anschluß (+Vcc) der Hauptversorgung verbunden ist und andererseits über einen steuerbaren Hilfsschalter (T5) mit einem zweiten Anschluß (-Vcc) der Hauptversorgung verbunden ist,
**daß** der zweite Anschluß des Hilfskondensators mit der Ausgangsstufe und dem zweiten Zweirichtungsschalter (T4,D4) verbunden ist, und
**daß** der Hilfsschalter (T5) offen ist, wenn der Transistor des ersten Zweirichtungsschalters (T3,D3) leitend ist und umgekehrt.

6. Verfahren nach Anspruch 5, **dadurch gekennzeichnet, daß** während der vertikalen Abtastung des Punkts der Hilfsschalter (T5) geschlossen ist und während des schnellen Rücklaufs des Punkts der Hilfsschalter (T5) geöffnet ist.

7. Verfahren nach Anspruch 5 oder Anspruch 6, **dadurch gekennzeichnet, daß** der Transistor des ersten Zweirichtungsschalters zwischen dem ersten Anschluß des Hilfskondensators (C) und dem ersten Anschluß (+Vcc) der Hauptversorgung angeordnet ist und daß die im Hilfskondensator gespeicherte Energie verwendet wird, um den Transistor (T3) des ersten Zweirichtungsschalters leitend zu machen.

8. Verfahren nach Anspruch 7, **dadurch gekennzeichnet, daß** die Gate-Elektrode des Transistors (T3) des ersten Zweirichtungsschalters mit dem ersten Anschluß des Hilfskondensators verbunden wird, um diesen Transistor leitend zu machen, und daß die Gate-Elektrode des Transistors (T3) des ersten Zweirichtungsschalters mit seiner Source-Elektrode verbunden wird, um diesen Transistor zu sperren.

9. Verfahren nach einem der Ansprüche 2 bis 8, kombiniert mit Anspruch 3, **dadurch gekennzeichnet, daß** ein Bootstrap-Kondensator (Cboot) zwischen der Source-Elektrode und der Gate-Elektrode des ersten Transistors (T1) der Ausgangsstufe angeordnet ist, und daß die in dem Bootstrap-Kondensator gespeicherte Energie verwendet wird, um während der vertikalen Abtastung des Punkts den Transistor (T4) des zweiten Zweirichtungsschalters leitend zu machen.

10. Verfahren nach Anspruch 9, **dadurch gekennzeichnet, daß** während der vertikalen Abtastung des Punkts der Bootstrap-Kondensator (Cboot) mit der Gate-Elektrode des Transistors (T4) des zweiten Zweirichtungsschalters verbunden ist und daß während des schnellen Rücklaufs des Punkts die Gate-Elektrode des Transistors (T4) des zweiten Zweirichtungsschalters mit seiner Source-Elektrode verbunden ist.

11. Verfahren nach einem der vorstehenden Ansprüche, **dadurch gekennzeichnet, daß** während der vertikalen Abtastphase des Punkts die Transistoren (T1,T2) der Ausgangsstufe in einem D-Betrieb unter Berücksichtigung eines Anweisungssignals (SC) gesteuert werden und daß während der schnellen Rücklaufphase des Punkts der erste Transistor (T1) der Ausgangsstufe leitend gemacht wird.

12. Verfahren nach einem der vorstehenden Ansprüche, **dadurch gekennzeichnet, daß** während der vertikalen Abtastphase des Punkts die Transistoren (T1,T2) der Ausgangsstufe in einem D-Betrieb unter Berücksichtigung eines Anweisungssignals gesteuert werden und daß das Anweisungssignal (SC), rückgekoppelt durch den Strom (IDV), der durch die Ablenkschaltung fließt, verstärkt wird, um so ein Fehlersignal (ε) auszugeben, das Überschreiten einer vorgegebenen Schwelle durch das Fehlersignal (ε) erfaßt wird und die schnelle Rücklaufphase des Punkts ausgelöst wird, wenn das Fehlersignal die Schwelle überschreitet.

13. Vorrichtung zur Steuerung einer Schaltung zur vertikalen Ablenkung (vertikale Ablenkschaltung) eines einen Bildschirm abtastenden Punkts, mit
einer von einer Hauptversorgung gespeisten Ausgangsverstärkerstufe (ETS) zur Steuerung der vertikalen Abtastung des Punkts,
einer Hilfsversorgung (ALM), die für einen schnellen Rücklauf des Punkts der vertikalen Ablenkschaltung eine Überspannung bereitstellen kann,
**dadurch gekennzeichnet,**
**daß** die Ausgangsstufe (ETS) eine Stufe mit mindestens zwei Transistoren (T1,T2) ist, die zumindest für die Steuerung der vertikalen Abtastung des Punkts im D-Betrieb arbeiten können, wobei diese Stufe mit einem Glättungsfilter (F) verknüpft ist, das mit dem gemeinsamen Anschluß (BBS) der zwei Transistoren verbunden ist,
**daß** die Vorrichtung aufweist: einen ersten steuerbaren Zweirichtungsschalter (T3,D3), der mit der Ausgangsstufe und der Hilfsversorgung (ALM) verbunden ist, einen zweiten steuerbaren Zweirichtungsschalter (T4,D4), der zwischen einem ersten Transistor (T1) der Ausgangsstufe und einem ersten Anschluß (+Vcc) der Hauptversorgung angeordnet ist, sowie Regelungseinrichtungen (PWM, COM1, COM2), die in der Lage sind,
die Transistoren (T1,T2) der Ausgangsstufe in den D-Betrieb zu steuern,
den ersten Schalter (T3,D3) so zu steuern, um einen Stromfluß über diesen ersten Schalter und die Abgabe der Überspannung zu erlauben, und
den zweiten Schalter (T4,D4) so zu steuern, um während der vertikalen Abtastung des Punkts den Stromfluß über den ersten Schalter zu verhindern und somit während der vertikalen Abtastung des Punkts die Abgabe der Überspannung zu verhindern.

14. Vorrichtung nach Anspruch 13, **dadurch gekennzeichnet, daß** jeder Transistor (T1,T2) der Ausgangsstufe eine Diode (D1,D2) aufweist, die antiparallel zu seinen Anschlüssen angeordnet sind.

15. Vorrichtung nach Anspruch 13 oder Anspruch 14, **dadurch gekennzeichnet,**
**daß** der erste Zweirichtungsschalter einen Transistor (T3) und eine antiparallel zu den Anschlüssen des Transistors (T3) angeordnete Diode (D3) aufweist, deren Anode mit dem ersten Transistor (T1) der Ausgangsstufe verbunden ist,
**daß** der zweite Zweirichtungsschalter einen Transistor (T4), der seriell zwischen dem ersten Transistor (T1) der Ausgangsstufe und dem ersten Anschluß (+Vcc) der Hauptversorgung angeordnet ist, und eine antiparallel zu den Anschlüssen des Transistors (T4) angeordnete Diode (D4) aufweist, deren Kathode mit dem ersten Transistor (T1) der Ausgangsstufe verbunden ist und deren Anode mit dem ersten Anschluß (+Vcc) der Hauptversorgung verbunden ist.

16. Vorrichtung nach Anspruch 15, **dadurch gekennzeichnet,**
**daß** die Hilfsversorgung einen Hilfskondensator (C) aufweist, dessen erster Anschluß einerseits über den ersten Zweirichtungsschalter (T3,D3) mit dem ersten Anschluß (+Vcc) der Hauptversorgung verbunden ist und andererseits über einen steuerbaren Hilfsschalter (T5) mit einem zweiten Anschluß (-Vcc) der Hauptversorgung verbunden ist,
**daß** der zweite Anschluß des Hilfskondensators mit der Ausgangsstufe und dem zweiten Zweirichtungsschalter (T4,D4) verbunden ist.

17. Vorrichtung nach Anspruch 16, **dadurch gekennzeichnet, daß** die Regelungseinrichtungen einen ersten steuerbaren Umschalter (COM1) aufweisen, der mit den zwei Anschlüssen des Hilfskondensators (C) und der Gate-Elektrode des Transistors (T3) des ersten Zweirichtungsschalters verbunden ist, und einen ersten Zustand besitzt, in welchem der erste Umschalter die Gate-Elektrode und die Source-Elektrode des Transistors des ersten Zweirichtungsschalters miteinander verbindet, und einen zweiten Zustand besitzt, in welchem er die Gate-Elektrode des Transistors des ersten Zweirichtungsschalters mit dem zweiten Anschluß des Hilfskondensators verbindet.

18. Vorrichtung nach Anspruch 17, **dadurch gekennzeichnet,**
**daß** der erste steuerbare Umschalter (COM1) aufweist: einen Schalttransistor (TCM10), der zwischen der Gate-Elektrode und der Source-Elektrode des Transistors des ersten Zweirichtungsschalters angeordnet ist, eine Widerstandsteilerbrücke, die seriell mit einem Steuertransistor zwischen dem zweiten Anschluß des Hilfskondensators und dem zweiten Anschluß (-Vcc) der Hauptversorgung angeordnet ist,
**daß** die Gate-Elektrode des Transistors des ersten Zweirichtungsschalters über eine Strombegrenzungseinrichtung (R13) mit dem zweiten Anschluß des Hilfskondensators verbunden ist, und
**daß** die Gate-Elektrode des Schalttransistors mit dem Mittelpunkt (PM10) der Teilerbrücke verbunden ist.

19. Vorrichtung nach Anspruch 18, **dadurch gekennzeichnet,**
**daß** die Teilerbrücke einen ersten Widerstand (R11), der zwischen dem Mittelpunkt und dem zweiten Anschluß der Hauptversorgung angeordnet ist, und einen zweiten Widerstand (R12) aufweist, der zwischen dem Mittelpunkt und dem zweiten Anschluß des Hilfskondensators angeordnet ist, und
**daß** das Verhältnis zwischen dem Wert dieses ersten Widerstands und der Summe der Werte der zwei Widerstände zwischen 0,25 und 0,5 liegt.

20. Vorrichtung nach Anspruch 15, **dadurch gekennzeichnet, daß** der erste Zweirichtungsschalter (T3,D3) seriell zwischen der Hilfsversorgung (ALM) und dem ersten Transistor (T1) der Ausgangsstufe angeordnet ist.

21. Vorrichtung nach einem der Ansprüche 13 bis 20, kombiniert mit Anspruch 15, **dadurch gekennzeichnet,**
**daß** die Ausgangsstufe einen Bootstrap-Kondensator (Cboot) aufweist, der mit dem ersten Transistor (T1) dieser Ausgangsstufe verbunden ist, wobei der Bootstrap-Kondensator einen ersten Anschluß (BCB1), der mit der Gate-Elektrode des ersten Transistors der Ausgangsstufe verbunden ist, und einen zweiten Anschluß (BCB2) aufweist, der mit dem Glättungsfilter verbunden ist,
**daß** die Regelungseinrichtungen einen zweiten steuerbaren Umschalter (COM2) aufweisen, der
über eine Diode (DD2), deren Anode mit dem ersten Anschluß des Bootstrap-Kondensators verbunden ist, mit dem ersten Anschluß des Bootstrap-Kondensators verbunden ist, und
mit der Source-Elektrode und der Gate-Elektrode des Transistors (T4) des zweiten Zweirichtungsschalters verbunden ist,
und **daß** dieser zweite Umschalter einen ersten Zustand besitzt, in welchem der zweite Umschalter (COM2) die Gate-Elektrode und die Source-Elektrode des Transistors des zweiten Zweirichtungsschalters miteinander verbindet, und einen zweiten Zustand besitzt, in welchem er die Gate-Elektrode des Transistors des zweiten Zweirichtungsschalters mit der Kathode der Diode verbindet.

22. Vorrichtung nach Anspruch 21, **dadurch gekennzeichnet,**
**daß** der zweite steuerbare Umschalter (COM2) aufweist: einen Schalttransistor (TCM20), der zwischen der Gate-Elektrode und der Source-Elektrode des Transistors (T4) des zweiten Zweirichtungsschalters angeordnet ist, eine Widerstandsteilerbrücke, die seriell mit einem Steuertransistor zwischen der Kathode der Diode (DD2) und dem zweiten Anschluß (-Vcc) der Hauptversorgung angeordnet ist,
**daß** die Gate-Elektrode des Transistors des zweiten Zweirichtungsschalters über eine Strombegrenzungseinrichtung mit der Kathode der Diode (DD2) verbunden ist, und
**daß** die Gate-Elektrode des Schalttransistors mit dem Mittelpunkt der Teilerbrücke (PM20) verbunden ist.

23. Vorrichtung nach Anspruch 22, **dadurch gekennzeichnet,**
**daß** die Teilerbrücke einen ersten Widerstand (R21), der zwischen dem Mittelpunkt und dem zweiten Anschluß der Hauptversorgung angeordnet ist, und einen zweiten Widerstand (R22) aufweist, der zwischen dem Mittelpunkt und der Kathode der Diode angeordnet ist, und
**daß** das Verhältnis zwischen dem Wert dieses ersten Widerstands und der Summe der Werte der zwei Widerstände kleiner als 0,4 ist.

24. Vorrichtung nach einem der Ansprüche 13 bis 23, **dadurch gekennzeichnet,**
**daß** während der Steuerung der vertikalen Abtastung des Punkts die Regelungseinrichtungen die Transistoren (T1,T2) der Ausgangsstufe in einem D-Betrieb unter Berücksichtigung eines am Eingang der Vorrichtung anliegenden Anweisungssignals steuern, den ersten Zweirichtungsschalter (T3,D3) öffnen und den zweiten Zweirichtungsschalter (T4,D4) schließen, und
**daß** während der Steuerung des schnellen Rücklaufs des Punkts die Regelungseinrichtungen den ersten Transistor (T1) der Ausgangsstufe leitend machen, den zweiten Zweirichtungsschalter (T4,D4) öffnen und den ersten Schalter schließen.

25. Vorrichtung nach den Ansprüchen 16 und 24, **dadurch gekennzeichnet, daß** während der Steuerung der vertikalen Abtastung des Punkts die Regelungseinrichtungen den Hilfsschalter (T5) schließen und daß während der Steuerung des schnellen Rücklaufs des Punkts die Regelungseinrichtungen den Hilfsschalter (T5) öffnen.

26. Vorrichtung nach Anspruch 24 oder Anspruch 25, **dadurch gekennzeichnet,**
**daß** sie eine Vorverstärkerstufe (PMP) aufweist, die das Anweisungssignal (SC), rückgekoppelt durch den Strom (IDV), der durch die Ablenkschaltung fließt, empfängt und ein Fehlersignal (ε) ausgibt, und
**daß** sie ferner Detektionseinrichtungen (DTF) aufweist, die das Überschreiten einer vorgegebenen Schwelle durch das Fehlersignal (ε) erfassen können, und
**daß** die Regelungseinrichtungen die schnelle Rücklaufphase des Punkts auslösen, wenn das Fehlersignal die Schwelle überschreitet.

27. Vorrichtung nach einem der Ansprüche 13 bis 26, **dadurch gekennzeichnet,**
**daß** die Ausgangsstufe (ETS) zwei weitere Transistoren (T10,T20) aufweist, die zumindest für die Steuerung der vertikalen Abtastung des Punkts im D-Betrieb arbeiten können, wobei die vier Transistoren eine vollständige Brückenschaltung bilden, und
**daß** das Glättungsfilter (F) zwischen dem gemeinsamen Anschluß der zwei ersten Transistoren und dem gemeinsamen Anschluß der zwei weiteren Transistoren angeordnet ist und sich beiderseits der Ablenkschaltung verteilt.

28. Vorrichtung nach einem der Ansprüche 13 bis 27, **dadurch gekennzeichnet, daß** alle Transistoren Feldeffekttransistoren mit isolierter Gate-Elektrode sind, deren Source-Elektrode mit dem Substrat verbunden ist, um die zugehörige antiparallel angeordnete Diode zu bilden, und dadurch, daß sie in Form einer integrierten Schaltung ausgeführt ist.

29. Fernseher mit einem Bildschirm, einer Schaltung zur vertikalen Ablenkung eines den Bildschirm abtastenden Punkts und einer Vorrichtung zur Steuerung der vertikalen Ablenkschaltung, **dadurch gekennzeichnet, daß** die Vorrichtung zur Steuerung der vertikalen Ablenkschaltung eine Vorrichtung gemäß einem der Ansprüche 13 bis 28 ist.

30. Computermonitor mit einem Bildschirm, einer Schaltung zur vertikalen Ablenkung eines den Bildschirm abtastenden Punkts und einer Vorrichtung zur Steuerung der vertikalen Ablenkschaltung, **dadurch gekennzeichnet, daß** die Vorrichtung zur Steuerung der vertikalen Ablenkschaltung eine Vorrichtung gemäß einem der Ansprüche 13 bis 28 ist.
